# EUROPEAN PATENT APPLICATION

(11) **EP 4 366 485 A1**
(43) Date of publication of application: **08.05.2024**
(21) Application number: 23207482.3
(22) Date of filing: 02.11.2023
(51) Int. Cl.: H10K 59/122, H10K 59/123, H10K 59/124, H10K 59/131

(54) **DISPLAY PANEL**

(30) Priority: 02.11.2022 KR 20220144674
(71) Applicant: Samsung Display Co., Ltd., Gyeonggi-Do (KR)
(72) Inventor: HONG, Sungjin, Yongin-si (KR); KO, Yoomin, Yongin-si (KR); KIM, Sunho, Yongin-si (KR); PARK, Juchan, Yongin-si (KR); KIM, Hyewon, Yongin-si (KR); LEE, Pilsuk, Yongin-si (KR); CHOI, Chung Sock, Yongin-si (KR)
(74) Representative: Marks & Clerk LLP

(57) **Abstract**

A display panel includes first and second pixels each including a light emitting device including a first electrode and a second electrode and a transistor electrically connected to the second electrode, a first insulating layer disposed on the transistor of each of the first and second pixels, a conductive pattern disposed on the first insulating layer and including a first pattern corresponding to the first pixel and a second pattern corresponding to the second pixel and spaced apart from the first pattern, and a separator disposed between the first pattern and the second pattern and contacting a portion of the first insulating layer, which is exposed and not covered by the first and second patterns, to separate the second electrode of the first pixel from the second electrode of the second pixel.

## Description

### BACKGROUND

### 1. Technical Field

The disclosure relates to a display panel. The disclosure relates to a display panel with improved reliability.

### 2. Description of the Related Art

Multimedia electronic devices, such as televisions, mobile phones, tablet computers, computers, navigation devices, and game devices, include a display panel for displaying an image.

The display panel may include light emitting devices and a pixel driving unit to drive the light emitting devices. The light emitting devices included in the display panel emit a light in response to electrical characteristics controlled by the pixel driving unit in order to generate the image. Research on connections between the light emitting devices and the pixel driving unit is in progress to improve a reliability of the display panel.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

The disclosure provides a display panel with improved electrical reliability.

The disclosure provides a display panel with high resolution.

The technical objectives to be achieved by the disclosure are not limited to those described herein, and other technical objectives that are not mentioned herein would be clearly understood by a person skilled in the art from the description of the disclosure.

Embodiments provide a display panel that may include a first pixel including a light emitting device including a first electrode; and a second electrode; and a transistor electrically connected to the second electrode; a second pixel including a light emitting device including a first electrode; and a second electrode; and a transistor electrically connected to the second electrode; a first insulating layer disposed on the transistor of each of the first pixel and the second pixel; a conductive pattern disposed on the first insulating layer and including a first pattern corresponding to the first pixel and a second pattern corresponding to the second pixel and spaced apart from the first pattern; and a separator disposed between the first pattern and the second pattern and contacting a portion of the first insulating layer, which is exposed not covered by the first pattern and the second pattern, to separate the second electrode of the first pixel from the second electrode of the second pixel.

The display panel may further include a separation pattern disposed on the separator, wherein the separation pattern and the second electrode of each of the first pixel and the second pixel have a same structure.

The separator may include a bottleneck area adjacent to the first insulating layer and a wide area disposed at an upper side of the bottleneck area in a cross-section perpendicular to a direction in which the separator extends.

The first pattern may have a substantially closed-line shape in a plan view.

The conductive pattern may be insulated from the second electrode of the first pixel, and the conductive pattern receives a constant voltage.

The display panel may further include a connection wiring partially covered by the first insulating layer and electrically connecting the transistor of the first pixel to the second electrode of the first pixel.

The first pattern may be spaced apart from the first electrode of the first pixel.

The conductive pattern may have a single-layer structure and may include a transparent conductive material.

Each of the first insulating layer and the separator may include an organic material, and the conductive pattern may include a hydrophilic surface.

The second electrode of the first pixel may contact the first pattern, and at least a portion of an area where the second electrode of the first pixel contacts the first pattern may overlap the separator.

The first insulating layer may include a contact opening that exposes a portion of the connection wiring. The connection wiring may include a first layer; a second layer disposed on the first layer; and a third layer disposed on the second layer, the third layer and the first layer including a same material, an edge of each of the first layer and the third layer, exposed and not covered by the first insulating layer, protrudes more than an edge of the second layer, which is exposed and not covered by the first insulating layer, and the second electrode of the first pixel contacts a side surface of the second layer exposed and not covered by the first insulating layer.

The display panel may further include a second insulating layer disposed below the first insulating layer, covering a portion of the connection wiring, and including a first contact opening that exposes a portion of an upper surface of the connection wiring. The first insulating layer may include a light emitting opening that exposes a portion of the first electrode of the first pixel and a second contact opening corresponding to the first contact opening. The first pattern may include a first portion having a substantially closed-line shape in a plan view and a second portion extending from the first portion and overlapping the first contact opening in a plan view.

The second portion may contact the portion of the upper surface of the connection wiring, which is exposed through the first contact opening of the second insulating layer.

The display panel may further include an additional electrode disposed between the portion of the upper surface of the connection wiring, which is exposed through the first contact opening of the second insulating layer, and the second portion and the first electrode of the first pixel include a same material.

A portion of an upper surface of the first portion may contact the second electrode of the first pixel.

The first pattern may include a first layer, a second layer disposed on the first layer, and a third layer disposed on the second layer, an edge of each of the first layer and the third layer protrude more than an edge of the second layer, and the second electrode of the first pixel contacts a side surface of the second layer in the first portion.

The display panel may further include a third insulating layer disposed on the first insulating layer and includes a light emitting opening that exposes the first electrode of the first pixel and a separation opening, and the separator is disposed in the separation opening.

The first pattern may be integral with the first electrode of the first pixel.

The first pattern and the first electrode of the first pixel may be integral with the first pattern include a first layer including a transparent conductive material; a second layer disposed on the first layer and including a material different from the first layer; and a third layer disposed on the second layer and the first layer including a same material.

The first pattern and the first electrode of the first pixel may be integral with the first pattern further include a fourth layer including a transparent conductive material, and the fourth layer covers a side surface of each of the first layer, the second layer, and the third layer and an upper surface of the third layer.

Embodiments provide a display panel that may include a pixel including a light emitting device including a first electrode; a second electrode; and a transistor electrically connected to the second electrode; an insulating layer disposed on the transistor and including a light emitting opening that exposes a portion of the first electrode; a separator surrounding the light emitting opening in a plan view and contacting the insulating layer; and a separation pattern disposed on an upper surface of the separator and spaced apart from the second electrode. The first electrode may include a first portion overlapping the light emitting opening in a plan view; a second portion overlapping the separator in a plan view; and a third portion connecting the first portion and the second portion.

According to the above, the display panel is provided with the separator that reduces a short circuit defect between the electrodes of adjacent pixels, and thus, the electrical reliability of the display panel is improved.

According to the above, a contact resistance of a cathode is reduced, and thus, the electrical reliability of the display panel is improved, and the light emission efficiency of the display panel is enhanced.

According to the above, a size of the opening defined through the insulating layer is minimized, and thus, the display panel with high resolution is readily implemented.

At least some of the above and other features of the invention are set out in the claims.

### BRIEF DESCRIPTION OF THE DRAWINGS

The above and other advantages of the disclosure will become readily apparent by reference to the following detailed description when considered in conjunction with the accompanying drawings wherein:
FIG. 1 is a block diagram of a display device according to an embodiment;
FIGS. 2A and 2B are schematic diagrams of equivalent circuits of pixels according to an embodiment;
FIGS. 3A and 3B are schematic plan views of display panels according to embodiments;
FIGS. 4A to 4C are enlarged schematic plan views of areas of a display panel according to an embodiment;
FIG. 5A is an enlarged schematic cross-sectional view of a display panel taken along line I-I' of FIG. 4B according to an embodiment;
FIG. 5B is an enlarged schematic plan view of components of a display panel according to an embodiment;
FIGS. 5C and 5D are enlarged schematic cross-sectional views of an area AA' of FIG. 5A according to embodiments;
FIG. 6 is an enlarged schematic cross-sectional view of a display panel taken along line I-I' of FIG. 4B according to an embodiment;
FIG. 7A is an enlarged schematic cross-sectional view of a display panel taken along line I-I' of FIG. 4B according to an embodiment;
FIG. 7B is an enlarged schematic plan view of components of a display panel according to an embodiment;
FIGS. 7C and 7D are enlarged schematic cross-sectional views of an area BB' of FIG. 7A according to embodiments;
FIG. 7E is an enlarged schematic cross-sectional view of a display panel taken along line I-I' of FIG. 4B according to an embodiment;
FIG. 8A is an enlarged schematic cross-sectional view of a display panel taken along line I-I' of FIG. 4B according to an embodiment;
FIG. 8B is an enlarged schematic plan view of components of a display panel according to an embodiment;
FIGS. 8C and 8D are enlarged schematic cross-sectional views of an area CC' of FIG. 8A according to embodiments;
FIGS. 9A to 9D are schematic cross-sectional views of a method of manufacturing a display panel according to an embodiment;
FIGS. 10A to 10F are schematic cross-sectional views of a method of manufacturing a display panel according to an embodiment; and
FIGS. 11A to 11E are schematic cross-sectional views of a method of manufacturing a display panel according to an embodiment.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the disclosure, it will be understood that when an element (or area, layer, or portion) is referred to as being "on", "connected to" or "coupled to" another element or layer, it can be directly on, connected or coupled to the other element or layer or intervening elements or layers may be present.

Like numerals refer to like elements throughout. In the drawings, the thickness, ratio, and dimension of components are exaggerated for effective description of the technical content. In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

It will be understood that, although the terms first, second, etc. may be used herein to describe various elements, these elements should not be limited by these terms. These terms are only used to distinguish one element from another element. Thus, a first element discussed below could be termed a second element without departing from the teachings of the disclosure.

As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to another elements or features as shown in the figures.

It will be further understood that the terms "comprises," "comprising," "includes," and/or "including,", "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

The term "part" or "unit" as used herein is intended to mean a software component or a hardware component that performs a specific function. The hardware component may include, for example, a field-programmable gate array (FPGA) or an application-specific integrated circuit (ASIC). The software component may refer to an executable code and/or data used by the executable code in an addressable storage medium. Thus, the software components may be, for example, object-oriented software components, class components, and task components, and may include processes, functions, attributes, procedures, subroutines, segments of program code, drivers, firmware, micro codes, circuits, data, a database, data structures, tables, arrays, or variables.

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. The term "overlap" or "overlapped" means that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments will be described with reference to accompanying drawings.

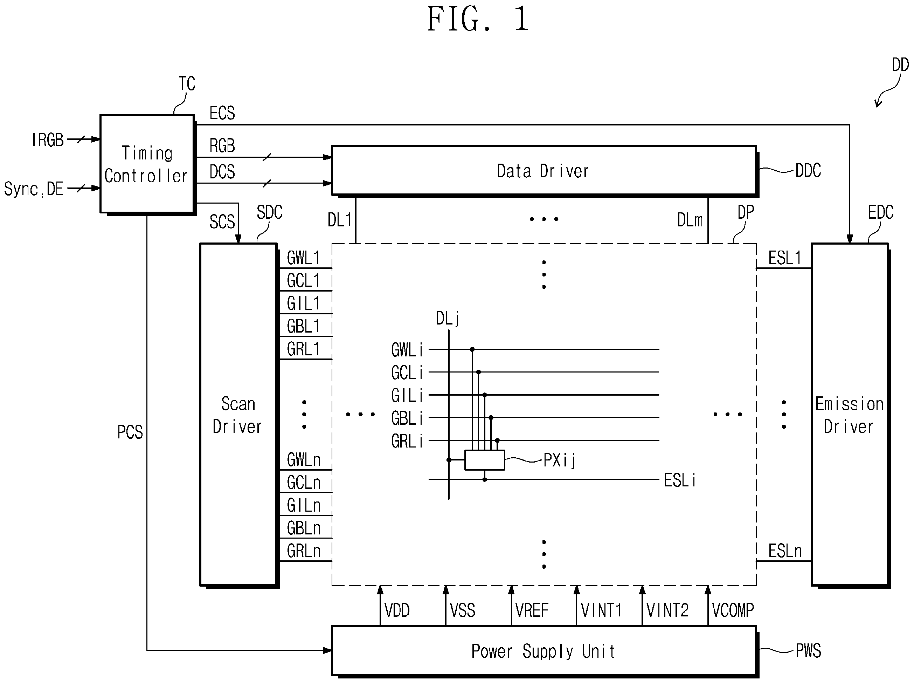

FIG. 1 is a block diagram of a display device DD according to an embodiment.

Referring to FIG. 1, the display device DD may include a timing controller TC, a panel driver, and a display panel DP. The display panel DP may be a light-emitting type display panel. The light-emitting type display panel DP may be an organic light emitting display panel or a quantum dot light emitting display panel. The panel driver may include a scan driver SDC, an emission driver EDC, and a data driver DDC.

The display panel DP may include scan lines GWL1 to GWLn, GCL1 to GCLn, GIL1 to GILn, GBL1 to GBLn, and GRL1 to GRLn, emission lines ESL1 to ESLn, and data lines DL1 to DLm. The display panel DP may include pixels connected to the scan lines GWL1 to GWLn, GCL1 to GCLn, GIL1 to GILn, GBL1 to GBLn, and GRL1 to GRLn, the emission lines ESL1 to ESLn, and the data lines DL1 to DLm. Each of "m" and "n" is an integer number greater than 1.

As an example, a pixel PXij (each of "i" and "j" is an integer number greater than 1) positioned to correspond to an i-th horizontal line (or an i-th pixel row) and a j-th vertical line (or a j-th pixel column) may be connected to an i-th first scan line GWLi, an i-th second scan line GCLi, an i-th third scan line GILi, an i-th fourth scan line GBLi, an i-th fifth scan line GRLi, a j-th data line DLj, and an i-th emission line ESLi.

The pixel PXij may include transistors and capacitors. The pixel PXij may receive a first power supply voltage (or a first driving voltage) VDD, a second power supply voltage (or a second driving voltage) VSS, a third power supply voltage (or a reference voltage) VREF, a fourth power supply voltage (or a first initialization voltage) VINT 1, a fifth power supply voltage (or a second initialization voltage) VINT2, and a sixth power supply voltage (or a compensation voltage) VCOMP from a power supply unit PWS.

The first power supply voltage VDD and the second power supply voltage VSS may have a voltage value set to allow a current to flow through a light emitting device. As an example, the first power supply voltage VDD may be set to have a voltage level higher than that of the second power supply voltage VSS.

The third power supply voltage VREF may be a voltage to initialize a gate of a driving transistor included in the pixel PXij. The third power supply voltage VREF may be used to implement a selectable grayscale using a difference in voltage between the third power supply voltage VREF and a data signal. To this end, the third power supply voltage VREF may be set to a selectable voltage within a voltage range of the data signal.

The fourth power supply voltage VINT1 may be used to initialize a storage capacitor included in the pixel PXij. The fourth power supply voltage VINT1 may be set to a voltage level lower than that of the third power supply voltage VREF. As an example, the fourth power supply voltage VINT1 may be set to a voltage level lower than a difference between the third power supply voltage VREF and a threshold voltage (or Vth) of the driving transistor. As an example, the fourth power supply voltage VINT1 may have a voltage level equal to or greater than about 4 volts and equal to or smaller than about 12 volts. In case that the fourth power supply voltage VINT1 is set to an electric potential equal to or greater than about 4 volts, characteristics of an N-type transistor may be readily overcome, however, the disclosure should not be limited thereto or thereby.

The fifth power supply voltage VINT2 may be a direct current voltage. The fifth power supply voltage VINT2 may be used to initialize a cathode of the light emitting device included in the pixel PXij.

The sixth power supply voltage VCOMP may provide a selectable current to the driving transistor in case that the threshold voltage of the driving transistor is compensated for.

Each of the fifth and sixth power supply voltages VINT2 and VCOMP may be set to a voltage level lower than the first power supply voltage VDD or the fourth power supply voltage VINT1 or may be set to a voltage level similar to or same as the third power supply voltage VREF, however, they should not be limited thereto or thereby. Each of the fifth and sixth power supply voltages VINT2 and VCOMP may be set to a voltage level similar to or the same as the first power supply voltage VDD.

FIG. 1 shows a structure in which all of the first, second, third, fourth, fifth, and sixth power supply voltages VDD, VSS, VREF, VINT1, VINT2, and VCOMP are provided from the power supply unit PWS, however, the disclosure should not be limited thereto or thereby. As an example, both of the first power supply voltage VDD and the second power supply voltage VSS may be provided regardless of the structure of the pixel PXij, and at least one of the third power supply voltage VREF, the fourth power supply voltage VINT1, the fifth power supply voltage VINT2, and the sixth power supply voltage VCOMP may not be provided according to the structure of the pixel PXij.

According to the disclosure, signal lines connected to the pixel PXij may be designed in various ways by taking into account the circuit structure of the pixel PXij.

The scan driver SDC may receive a first control signal SCS from the timing controller TC and may provide a scan signal to the first scan lines GWL1 to GWLn, the second scan lines GCL1 to GCLn, the third scan lines GIL1 to GILn, the fourth scan lines GBL1 to GBLn, and the fifth scan lines GRL1 to GRLn in response to the first control signal SCS.

The scan signal may be set to a gate-on-voltage to allow the transistors to be turned on in response to the scan signal.

As an example, the scan signal provided to a PMOS (P-channel metal oxide semiconductor) transistor may be set to a logic low level, and the scan signal provided to an NMOS (N-channel metal oxide semiconductor) transistor may be set to a logic high level. Hereinafter, the expression "the scan signal is provided" may mean that the scan signal is provided to the transistor, which is controlled thereby, with a logic level that turns on the transistor.

For the convenience of explanation, FIG. 1 shows one scan driver SDC, however, the disclosure should not be limited thereto or thereby. According to an embodiment, the display device DD may include multiple scan drivers to provide the scan signal to the first scan lines GWL1 to GWLn, the second scan lines GCL1 to GCLn, the third scan lines GIL1 to GILn, the fourth scan lines GBL1 to GBLn, and the fifth scan lines GRL1 to GRLn, respectively.

The emission driver EDC may provide emission signals to the emission lines ESL1 to ESLn in response to a second control signal ECS. As an example, the emission signals may be sequentially provided to the emission lines ESL1 to ESLn.

Each transistor connected to the emission lines ESL1 to ESLn may be the NMOS transistor. The emission signals provided to the emission lines ESL1 to ESLn may have a gate-off-voltage, for example, the logic high level. The transistors may be turned off when receiving the emission signals and may be turned on in other cases.

The second control signal ECS may include an emission start signal and clock signals, and the emission driver EDC may be implemented by a shift register that sequentially shifts the emission start signal with a pulse shape using the clock signals to sequentially generate and output the emission signals with a pulse shape.

The data driver DDC may receive a third control signal DCS and image data RGB from the timing controller TC. The data driver DDC may convert the image data RGB in a digital form to analog data signals. The data driver DDC may provide the data signals to the data lines DL1 to DLm in response to the third control signal DCS.

The third control signal DCS may include a data enable signal, a horizontal start signal, and a data clock signal to indicate an output of an effective data signal. As an example, the data driver DDC may include a shift register that shifts the horizontal start signal in synchronization with the data clock signal to generate a sampling signal, a latch that latches the image data RGB in response to the sampling signal, a digital-to-analog converter (or a decoder) that converts the latched image data, for example, data in the digital form to data signals in the analog form, and buffers (or amplifiers) that output the data signals to the data lines DL1 to DLm.

The power supply unit PWS may provide the first power supply voltage VDD, the second power supply voltage VSS, the third power supply voltage VREF to the display panel DP to drive the pixel PXij. The power supply unit PWS may provide at least one voltage of the fourth power supply voltage VINT1, the fifth power supply voltage VINT2, and the sixth power supply voltage VCOMP to the display panel DP.

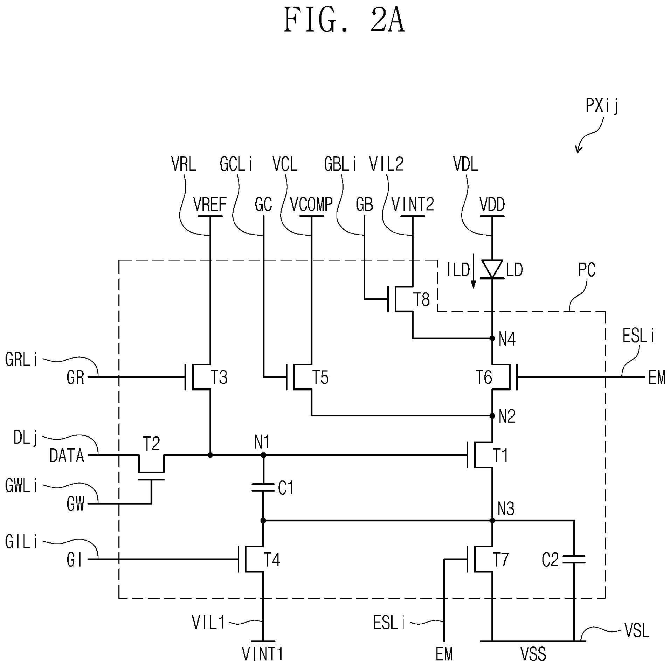

As an example, the power supply unit PWS may provide the first power supply voltage VDD, the second power supply voltage VSS, the third power supply voltage VREF, the fourth power supply voltage VINT1, the fifth power supply voltage VINT2, and the sixth power supply voltage VCOMP to the display panel DP respectively via a first power line VDL (or first driving voltage line, refer to FIG. 2A), a second power line VSL (or second driving voltage line, refer to FIG. 2A), a third power line (or a reference voltage line, refer to FIG. 2A) VRL, a fourth power line (or a first initialization voltage line, refer to FIG. 2A) VIL1, a fifth power line (or a second initialization voltage line, refer to FIG. 2A) VIL2, and a sixth power line (or a compensation voltage line, refer to FIG. 2A) VCL, which are shown in FIG. 2A.

The power supply unit PWS may be implemented by a power management integrated circuit (PMIC), however, the disclosure should not be limited thereto or thereby.

The timing controller TC may generate the first control signal SCS, the second control signal ECS, the third control signal DCS, and a fourth control signal PCS based on input image data IRGB, a synchronization signal Sync, for example, a vertical synchronization signal, a horizontal synchronization signal, etc., a data enable signal DE, and a clock signal. The first control signal SCS may be applied to the scan driver SDC, the second control signal ECS may be applied to the emission driver EDC, the third control signal DCS may be applied to the data driver DDC, and the fourth control signal PCS may be applied to the power supply unit PWS. The timing controller TC may rearrange the input image data IRGB to correspond to an arrangement of the pixels in the display panel DP and may generate the image data RGB (or frame data).

At least one of the scan driver SDC, the emission driver EDC, the data driver DDC, the power supply unit PWS, and the timing controller TC may be formed in the display panel DP or may be connected to the display panel DP after being implemented in an integrated circuit. At least two of the scan driver SDC, the emission driver EDC, the data driver DDC, the power supply unit PWS, and the timing controller TC may be implemented in a single integrated circuit. As an example, the data driver DDC and the timing controller TC may be provided in a single integrated circuit.

In the above descriptions, the display device DD is described with reference to FIG. 1, however, the display device DD should not be limited thereto or thereby. Signal lines may be added or omitted depending on the structure of the pixels. A connection relationship between one pixel and the signal lines may be changed. In a case where one of the signal lines is omitted, the omitted signal line may be replaced with another signal line.

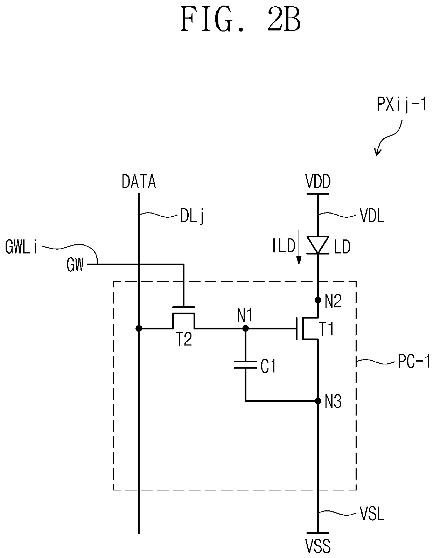

FIGS. 2A and 2B are schematic diagrams of equivalent circuits of pixels PXij and PXij-1 according to embodiments. FIGS. 2A and 2B show the equivalent circuit diagrams of the pixels PXij and PXij-1, which are connected to the i-th first scan line GWLi (hereinafter, referred to as a first scan line) and the j-th data line DLj (hereinafter, referred to as a data line).

Referring to FIG. 2A, the pixel PXij may include a light emitting device LD and a pixel driver PC. The light emitting device LD may be connected to the first driving voltage line VDL and the pixel driver PC.

The pixel driver PC may be connected to the scan lines GWLi, GCLi, GILi, GBLi, and GRLi, the data line DLj, the emission line ESLi, and the power lines VDL, VSL, VIL1, VIL2, VRL, and VCL. The pixel driver PC may include first, second, third, fourth, fifth, sixth, seventh, and eighth transistors T1, T2, T3, T4, T5, T6, T7, and T8, a first capacitor C1, and a second capacitor C2. Hereinafter, each of the first, second, third, fourth, fifth, sixth, seventh, and eighth transistors T1, T2, T3, T4, T5, T6, T7, and T8 will be described as the N-type transistor, however, the disclosure should not be limited thereto or thereby. According to an embodiment, a number of the first to eighth transistors T1 to T8 may be the N-type transistor, and the other of the first to eighth transistors T1 to T8 may be a P-type transistor, or each of the first to eighth transistors T1 to T8 may be the P-type transistor, and the disclosure should not be particularly limited.

A gate of the first transistor T1 may be connected to a first node N1. A first electrode of the first transistor T1 may be connected to a second node N2, and a second electrode of the first transistor T1 may be connected to a third node N3. The first transistor T1 may be a driving transistor. The first transistor T1 may control a driving current ILD flowing from the first driving voltage line VDL to the second driving voltage line VSL via the light emitting device LD in response to a voltage of the first node N1. The first driving voltage VDD may be set to a voltage with an electric potential higher than the second driving voltage VSS.

In the disclosure, the expression "the transistor is electrically connected to the signal line or the transistor is electrically connected to the transistor" may mean that a source, drain, or gate of one transistor is provided integral with the signal line or a source, drain, or gate of another transistor or it is connected to the signal line or the source, drain, or gate of another transistor via a connection electrode.

The second transistor T2 may include a gate connected to the first scan line GWLi, a first electrode connected to the data line DLj, and a second electrode connected to the first node N1. The second transistor T2 may provide a data signal DATA to the first node N1 in response to a write scan signal GW applied thereto via the first scan line GWLi. The second transistor T2 may be a switching transistor. The second transistor T2 may be turned on in case that the write scan signal GW is applied to the first scan line GWLi, and thus, the data line DLj may be electrically connected to the first node N1.

The third transistor T3 may be connected between the first node N1 and the reference voltage line VRL. A first electrode of the third transistor T3 may receive the reference voltage VREF via the reference voltage line VRL, and a second electrode of the third transistor T3 may be connected to the first node N1. In an embodiment, a gate of the third transistor T3 may receive a reset scan signal GR via the i-th fifth scan line GRLi (hereinafter, referred to as a fifth scan line). The third transistor T3 may be turned on in case that the reset scan signal GR is applied to the fifth scan line GRLi and may provide the reference voltage VREF to the first node N1.

The fourth transistor T4 may be connected between the third node N3 and the first initialization voltage line VIL1. A first electrode of the fourth transistor T4 may be connected to the third node N3, and a second electrode of the fourth transistor T4 may be connected to the first initialization voltage line VIL1 through which the first initialization voltage VINT1 is provided. A gate of the fourth transistor T4 may receive an initialization scan signal GI via the i-th third scan line GILi (hereinafter, referred to as a third scan line). The fourth transistor T4 may be turned on in case that the initialization scan signal GI is provided to the third scan line GILi and may provide the first initialization voltage VINT1 to the third node N3.

The fifth transistor T5 may be connected between the compensation voltage line VCL and the second node N2. A first electrode of the fifth transistor T5 may receive the compensation voltage VCOMP via the compensation voltage line VCL, and a second electrode of the fifth transistor T5 may be connected to the second node N2 to be electrically connected to the first electrode of the first transistor T1. A gate of the fifth transistor T5 may receive a compensation scan signal GC via the i-th second scan line GCLi (hereinafter, referred to as a second scan line). The fifth transistor T5 may be turned on in case that the compensation scan signal GC is provided to the second scan line GCLi and may provide the compensation voltage VCOMP to the second node N2, and thus, the threshold voltage (or Vth) of the first transistor T1 may be compensated for during a compensation period.

The sixth transistor T6 may be connected between the first transistor T1 and the light emitting device LD. In detail, a gate of the sixth transistor T6 may receive the emission signal EM via the i-th emission line ESLi (hereinafter, referred to as an emission line). A first electrode of the sixth transistor T6 may be connected to the cathode of the light emitting device LD via a fourth node N4, and a second electrode of the sixth transistor T6 may be connected to the first electrode of the first transistor T1 via the second node N2. The sixth transistor T6 may be referred to as a first emission control transistor. The sixth transistor T6 may be turned on in case that the emission signal EM is provided to the emission line ESLi, and thus, the light emitting device LD may be electrically connected to the first transistor T1.

The seventh transistor T7 may be connected between the second driving voltage line VSL and the third node N3. A first electrode of the seventh transistor T7 may be connected to the second electrode of the first transistor T1 via the third node N3, and a second electrode of the seventh transistor T7 may receive the second driving voltage VSS via the second driving voltage line VSL. A gate of the seventh transistor T7 may be electrically connected to the emission line ESLi. The seventh transistor T7 may be referred to as a second emission control transistor. The seventh transistor T7 may be turned on in case that the emission signal EM is provided to the emission line ESLi, and thus, the second electrode of the first transistor T1 may be electrically connected to the second driving voltage line VSL.

According to an embodiment, the sixth transistor T6 and the seventh transistor T7 are connected to the same emission line ESLi and are turned on in response to the same emission signal EM, however, this is an example. According to an embodiment, the sixth transistor T6 and the seventh transistor T7 may be independently turned on in response to different signals distinguished from each other. According to an embodiment, one of the sixth transistor T6 and the seventh transistor T7 may be omitted from the pixel driver PC.

The eighth transistor T8 may be connected between the second initialization voltage line VIL2 and the fourth node N4. For example, the eighth transistor T8 may include a gate connected to the i-th fourth scan line GBLi (hereinafter, referred to as a fourth scan line), a first electrode connected to the second initialization voltage line VIL2, and a second electrode connected to the fourth node N4. The eighth transistor T8 may provide the second initialization voltage VINT2 to the fourth node N4 corresponding to the cathode of the light emitting device LD in response to a black scan signal GB applied thereto via the fourth scan line GBLi. The cathode of the light emitting device LD may be initialized by the second initialization voltage VINT2.

According to an embodiment, a number of the second, third, fourth, fifth, sixth, seventh, and eighth transistors T2, T3, T4, T5, T6, T7, and T8 may be substantially simultaneously turned on in response to the same scan signal. As an example, the eighth transistor T8 and the fifth transistor T5 may be substantially simultaneously turned on in response to the same scan signal. As an example, the eighth transistor T8 and the fifth transistor T5 may be operated in response to the same compensation scan signal GC. Since the eighth transistor T8 and the fifth transistor T5 are turned on and off in response to the same compensation scan signal GC, the eighth transistor T8 and the fifth transistor T5 may be substantially simultaneously turned on and off. The second scan line GCLi and the fourth scan line GBLi may be substantially provided as a single scan line. Accordingly, the initialization of the cathode of the light emitting device LD and the compensation of the threshold voltage of the first transistor T1 may be performed at the same timing, however, the disclosure should not be limited thereto or thereby.

According to the disclosure, the initialization of the cathode of the light emitting device LD and the compensation of the threshold voltage of the first transistor T1 may be performed in response to the same power supply voltage. As an example, the compensation voltage line VCL and the second initialization voltage line VIL2 may be substantially provided as a single power line. The initialization operation of the cathode and the compensation operation of the driving transistor may be performed using one power supply voltage, and thus, a design for the drivers may be simplified. However, this is an example, and the disclosure should not be particularly limited.

The first capacitor C1 may be disposed between the first node N1 and the third node N3. The first capacitor C1 may be charged with a voltage corresponding to a difference between the voltage of the first node N1 and the voltage of the third node N3. The first capacitor C1 may be referred to as a storage capacitor.

The second capacitor C2 may be disposed between the third node N3 and the second driving voltage line VSL. For example, one electrode of the second capacitor C2 may be connected to the second driving voltage line VSL receiving the second driving voltage VSS, and the other electrode of the second capacitor C2 may be connected to the third node N3. The second capacitor C2 may be charged with electric charges corresponding to a difference in voltage between the second power supply voltage VSS and the third node N3. The second capacitor C2 may be referred to as a hold capacitor. The second capacitor C2 may have a higher storage capacity compared with the first capacitor C1. Accordingly, the second capacitor C2 may reduce a variation in voltage of the third node N3 according to a variation in voltage of the first node N1.

In an embodiment, the light emitting device LD may be connected to the pixel driver PC via the fourth node N4. The light emitting device LD may include an anode connected to the first driving voltage line VDL and the cathode opposite to the anode. In an embodiment, the light emitting device LD may be connected to the pixel driver PC through the cathode thereof. For example, according to the pixel PXij, a connection node at which the light emitting device LD is connected to the pixel driver PC may be the fourth node N4, and the fourth node N4 may correspond to a connection node between the first electrode of the sixth transistor T6 and the cathode of the light emitting device LD.

Accordingly, an electric potential of the fourth node N4 may correspond to an electric potential of the cathode of the light emitting device LD. For example, the anode of the light emitting device LD may be connected to the first driving voltage line VDL, the first driving voltage VDD that is a constant voltage may be applied to the anode, the cathode may be electrically connected to the first transistor T1 via the sixth transistor T6, and the electric potential of the cathode may be controlled. For example, an electric potential of the second node N2 corresponding to a source of the first transistor T1 may not be directly affected by characteristics of the light emitting device LD. Accordingly, even though the characteristics of the light emitting device LD are deteriorated due to a lifespan of the light emitting device LD, an influence of the deterioration in the characteristics of the light emitting device LD on a gate-source voltage (or Vgs) of the transistors constituting the pixel driver PC, especially the driving transistor T1, may be reduced. For example, since a range of change in an amount of current due to the deterioration of the light emitting device may be reduced, an image retention defect of the display panel according to the increase in usage time may be reduced, and a lifespan of the display panel may be improved.

As shown in FIG. 2B, the pixel PXij-1 may include a pixel driver PC-1 including two transistors T1 and T2 and one capacitor C1. The pixel driver PC-1 may be connected to a light emitting device LD, a first scan line GWLi, a data line DLj, and a second driving voltage line VSL. The pixel driver PC-1 shown in FIG. 2B may correspond to a circuit configuration obtained by removing the third to eighth transistors T3 to T8 and one capacitor C2 from the pixel driver PC shown in FIG. 2A.

Each of the first and second transistors T1 and T2 may be an N-type transistor or a P-type transistor. In an embodiment, each of the first and second transistors T1 and T2 will be described as the N-type transistor.

The first transistor T1 may include a gate connected to a first node N1, a first electrode connected to a second node N2, and a second electrode connected to a third node N3. The second node N2 may be connected to a first driving voltage line VDL, and the third node N3 may be connected to the second driving voltage line VSL. The first transistor T1 may be connected to the light emitting device LD via the second node N2 and may be connected to the second driving voltage line VSL via the third node N3. The first transistor T1 may be a driving transistor.

The second transistor T2 may include a gate receiving a write scan signal GW via a first scan line GWLi, a first electrode connected to the data line DLj, and a second electrode connected to the first node N1. The second transistor T2 may provide a data signal DATA to the first node N1 in response to the write scan signal GW applied thereto via the first scan line GWLi.

The capacitor C1 may include an electrode connected to the first node N1 and an electrode connected to the third node N3. The capacitor C1 may be charged with the data signal DATA applied to the first node N1.

The light emitting device LD may include an anode and a cathode. In an embodiment, the anode of the light emitting device LD may be connected to the first driving voltage line VDL, and the cathode of the light emitting device LD may be connected to the pixel driver PC-1 via the second node N2. In an embodiment, the cathode of the light emitting device LD may be connected to the first transistor T1. The light emitting device LD may emit light in response to an amount of current flowing through the first transistor T1 of the pixel driver PC-1.

The second node N2 at which the cathode of the light emitting device LD is connected to the pixel driver PC-1 may correspond to a drain of the first transistor T1. The light emitting device LD may be connected to the pixel driver PC-1 via the second node N2. For example, in the pixel PXij-1 shown in FIG. 2B, a connection node at which the light emitting device LD is connected to the pixel driver PC-1 may be the second node N2, and the second node N2 may correspond to a connection node between the first electrode of the first transistor T1 and the cathode of the light emitting device LD.

For example, in the case where the driving transistor is the N-type transistor, the display panel may prevent a variation in a gate-source voltage of the first transistor T1, which is caused by the light emitting device LD. Accordingly, the range of change in the amount of current due to deterioration of the light emitting device LD may be reduced, the image retention defect of the display panel according to the increase in usage time may be reduced, and the lifespan of the display panel may be improved.

FIGS. 2A and 2B show the circuit configurations of the pixel drivers PC and PC-1 according to embodiments. In the disclosure, the display panel should not be particularly limited, and the number and arrangement of the transistors and the number and arrangement of the capacitors may be designed in various ways as long as a circuit is connected to the cathode of the light emitting device LD.

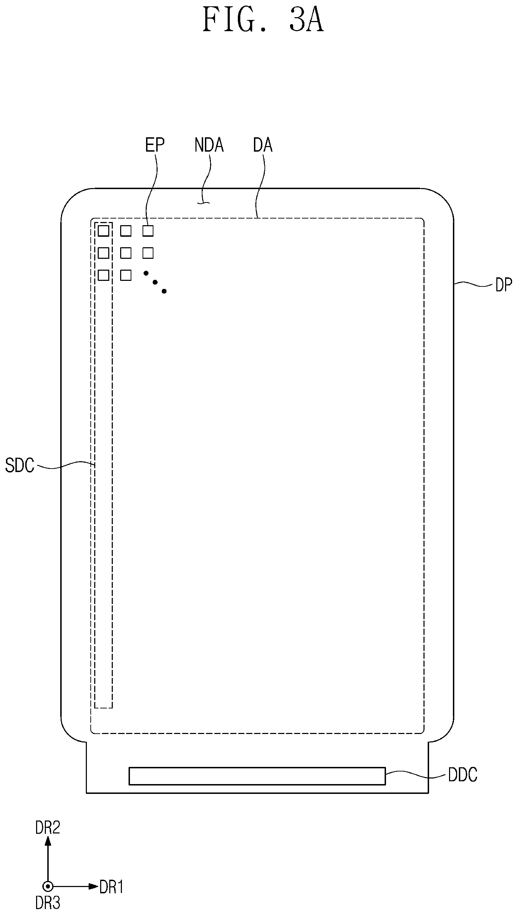

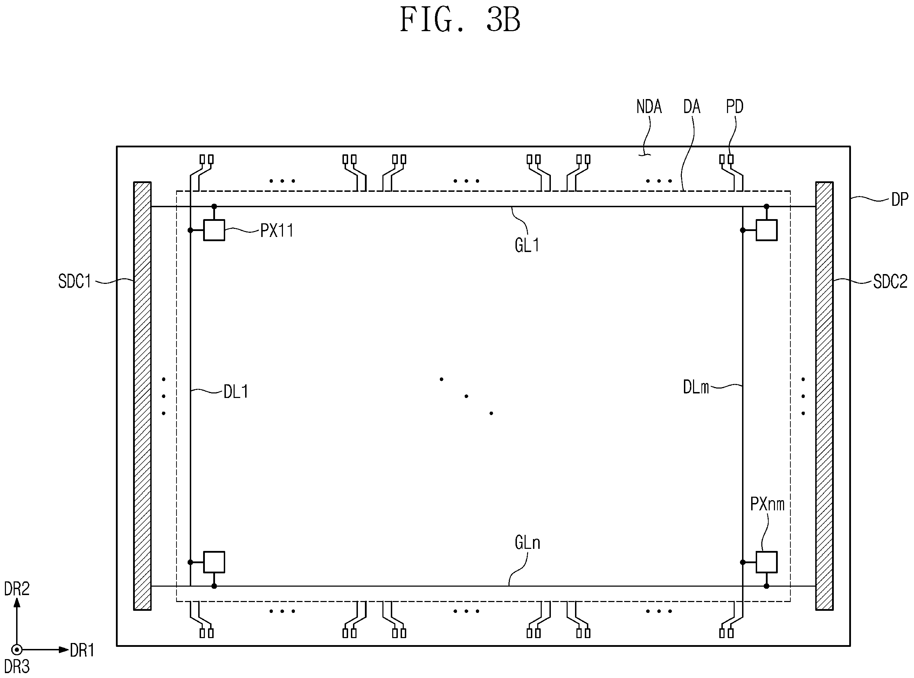

FIGS. 3A and 3B are schematic plan views of display panels DP according to embodiments. In FIGS. 3A and 3B, some components may be omitted, and for the convenience of explanation, some components mounted on the display panel DP may not be omitted. Hereinafter, the disclosure will be described with reference to FIGS. 3A and 3B. Referring to FIG. 3A, the display panel DP may include a display area DA and a peripheral area NDA. The display area DA may include light emitting parts EP.

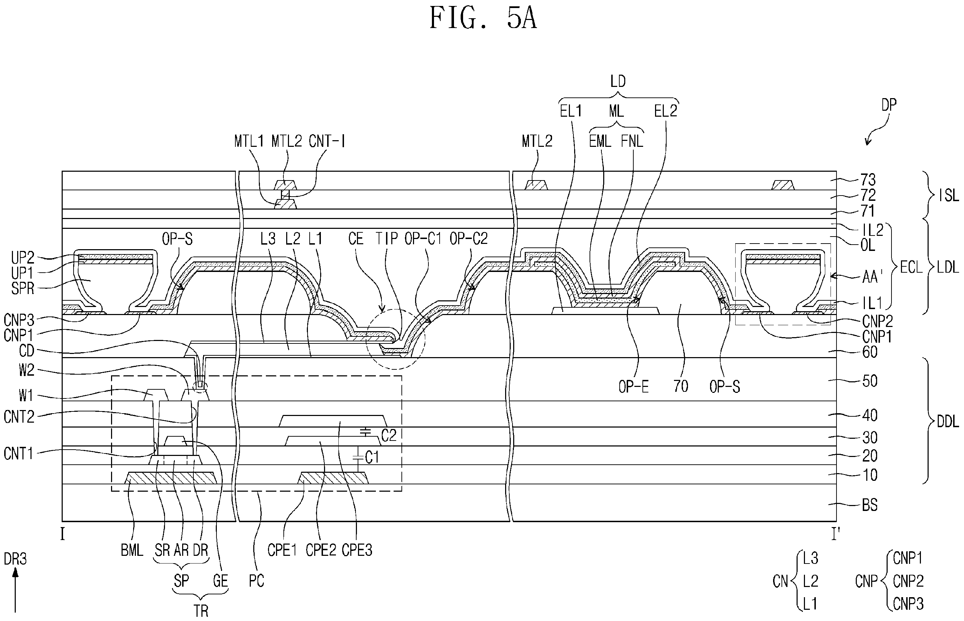

The light emitting parts EP may be areas where the pixels emit the light. In detail, each of the light emitting parts EP may correspond to a light emitting opening OP-E (refer to FIG. 5A) described later.

The peripheral area NDA may be defined adjacent to the display area DA. In an embodiment, the peripheral area NDA may have a shape surrounding an edge of the display area DA, however, this is an example. According to an embodiment, the peripheral area NDA may be defined adjacent to one side or a side of the display area DA or may be omitted, but should not be particularly limited.

In an embodiment, a scan driver SDC and a data driver DDC may be mounted on the display panel DP. The scan driver SDC may be disposed in the display area DA, and the data driver DDC may be disposed in the peripheral area NDA. The scan driver SDC may overlap at least a number of the light emitting parts EP arranged (or disposed) in the display area DA when viewed in a plan view. As the scan driver SDC is disposed in the display area DA, a size of the peripheral area NDA may be reduced compared with that of a display panel in which a scan driver is disposed in a peripheral area, and thus, a narrow bezel of the display device DD (refer to FIG. 1) may be readily implemented. However, the disclosure should not be limited thereto or thereby, and the scan driver SDC may be disposed in the peripheral area NDA.

Different from the scan driver SDC shown in FIG. 3A, the scan driver SDC may be provided in two parts distinguished from each other. The two scan drivers SDC may be respectively disposed at left and right sides of the display area DA to be spaced apart from each other. According to an embodiment, three or more scan drivers SDC may be employed, and the number of the scan drivers SDC should not be particularly limited.

FIG. 3A shows a representative example of the display device DD (refer to FIG. 1), however, the data driver DDC may be disposed in the display area DA. In case that the data driver DDC is disposed in the display area DA, a number of the light emitting parts EP arranged in the display area DA may overlap the data driver DDC when viewed in the plan view.

The data driver DDC may be provided in a separate driving chip independently formed from the display panel DP and may be connected to the display panel DP, however, this is an example. According to an embodiment, the data driver DDC may be formed through the same process as the scan driver SDC to form the display panel DP, and it should not be limited thereto or thereby.

Referring to FIG. 3B, the display device DD (refer to FIG. 1) may include the display panel DP having long sides extending in a first direction DR1. In an embodiment, the display device may include scan drivers SDC1 and SDC2. The scan drivers SDC1 and SDC2 may include a first scan driver SDC1 and a second scan driver SDC2, which are spaced apart from each other in the first direction DR1.

The first scan driver SDC1 may be connected to a number of scan lines of scan lines GL1 to GLn, and the second scan driver SDC2 may be connected to the other scan lines among the scan lines GL1 to GLn. As an example, the first scan driver SDC1 may be connected to odd-numbered scan lines among the scan lines GL1 to GLn, and the second scan driver SDC2 may be connected to even-numbered scan lines among the scan lines GL1 to GLn.

For the convenience of explanation, FIG. 3B shows pads PD of data lines DL1 to DLm. The pads PD may be placed at ends of the data lines DL1 to DLm. The data lines DL1 to DLm may be connected to the data driver DDC (refer to FIG. 3A) via the pads PD.

According to the disclosure, the pads PD may be arranged in areas of the peripheral area NDA, which are spaced apart from each other with the display area DA interposed therebetween. As an example, a number of pads among the pads PD may be arranged in an upper portion of the display panel DP, which is adjacent to a first scan line GL1 among the scan lines GL1 to GLn, and the other pads among the pads PD may be arranged in a lower portion of the display panel DP, which is adjacent to the last scan line GLn among the scan lines GL1 to GLn. In an embodiment, pads, which are connected to odd-numbered data lines, among the pads PD may be arranged in the upper portion, and pads, which are connected to even-numbered data lines, among the pads PD may be arranged in the lower portion. Although not shown in figures, the data driver may include three upper data drivers connected to the pads PD arranged in the upper portion and three lower data drivers connected to the pads PD arranged in the lower portion, however, these are examples. According to an embodiment, the pads PD may be connected to two data drivers arranged in the upper and lower portions. According to an embodiment, the pads PD may be arranged in one side portion or a side portion and may be connected to a single data driver, however, the disclosure should not be particularly limited. FIG. 3B also includes pixels PX11 and PXnm and appropriate connections thereto.

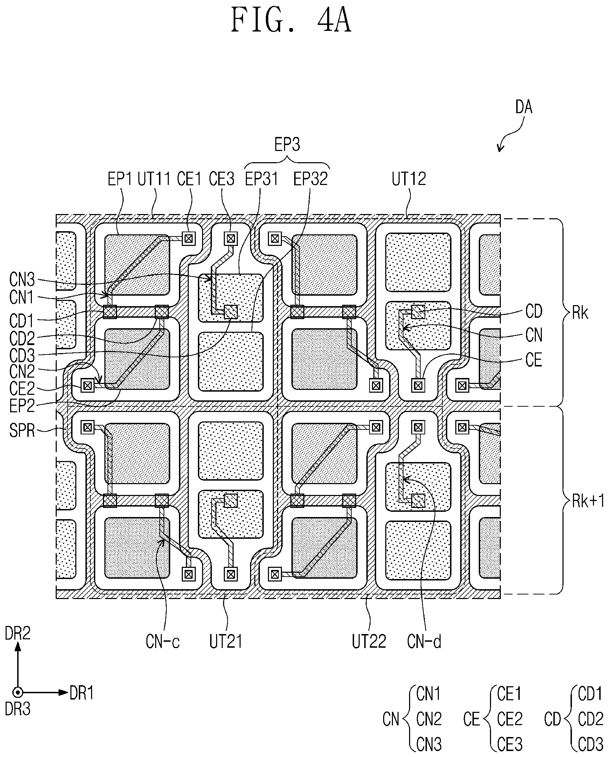

FIGS. 4A to 4C are enlarged schematic plan views of a part of the display area according to an embodiment. FIG. 4A shows light emitting units UT11, UT12, UT21, and UT22 arranged in two rows by two columns. The light emitting parts arranged in a first row Rk may include light emitting parts constituting the light emitting unit UT11 arranged in a first row and a first column and the light emitting unit UT12 arranged in the first row and a second column, and the light emitting parts arranged in a second row Rk+1 may include light emitting parts constituting the light emitting unit UT21 arranged in a second row and the first column and the light emitting unit UT22 arranged in the second row and the second column. FIGS. 4A to 4C show a separator SPR, light emitting parts EP1, EP2, and EP3 disposed in areas divided by the separator SPR, connection wirings CN1, CN2, and CN3, an anode (or a first electrode) EL1, and cathodes (or second electrodes) EL2_1, EL2_2, and EL2_3 among components of the display panel DP (refer to FIG. 1).

Each of the light emitting parts EP1, EP2, and EP3 may correspond to the light emitting opening OP-E (refer to FIG. 5A) described later. For example, each of the light emitting parts EP1, EP2, and EP3 may be an area from which the light is emitted by the light emitting device LD (refer to FIG. 2A or FIG. 2B) and may correspond to a unit providing the image displayed through the display panel DP.

The light emitting parts EP1, EP2, and EP3 may include a first light emitting part EP1, a second light emitting part EP2, and a third light emitting part EP3. The first light emitting part EP1, the second light emitting part EP2, and the third light emitting part EP3 may emit lights having different colors from each other. As an example, the first light emitting part EP1 may emit a red light, the second light emitting part EP2 may emit a green light, and the third light emitting part EP3 may emit a blue light, however, a combination of colors of the first, second, and third light emitting parts EP1, EP2, and EP3 should not be limited thereto or thereby.

Among the light emitting parts EP1, EP2, and EP3, the third light emitting part EP3 may include two sub-light emitting parts EP31 and EP32 spaced apart from each other in a second direction DR2, however, this is an example. According to an embodiment, the third light emitting part EP3 may be provided in a single pattern having an integral shape like the other light emitting parts EP1 and EP2, or at least one of the other light emitting parts EP1 and EP2 may include sub-light emitting parts, and the disclosure should not be particularly limited.

In an embodiment, the light emitting parts arranged in the first row Rk may include light emitting parts in a structure in which the light emitting unit UT11 arranged in the first row and the first column and the light emitting unit UT12 arranged in the first row and the second column are repeatedly and alternately arranged with each other. The light emitting parts arranged in the second row Rk+1 may include light emitting parts in a structure in which the light emitting unit UT21 arranged in the second row and the first column and the light emitting unit UT22 arranged in the second row and the second column are repeatedly and alternately arranged with each other. The shape and the arrangement of the third light emitting part constituting the light emitting unit UT11 may be axisymmetric with that of the third light emitting part constituting the light emitting unit UT21 with respect to the axis parallel to the first direction DR1. The shape and the arrangement of the third light emitting part constituting the light emitting unit UT12 may be axisymmetric with that of the third light emitting part constituting the light emitting unit UT22 with respect to the axis parallel to the first direction DR1.

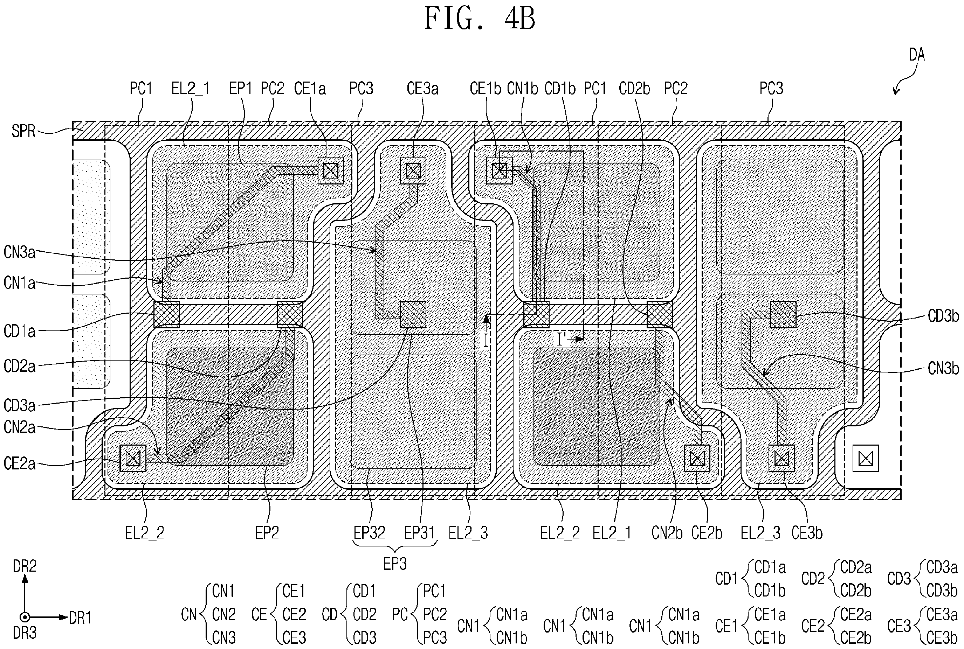

Hereinafter, the light emitting unit UT11 arranged in the first row and the first column will be described in detail. For the convenience of explanation, FIG. 4B shows the cathodes EL2_1, EL2_2, and EL2_3, pixel drivers PC1, PC2, and PC3, and the connection wirings CN1, CN2, and CN3. The cathodes EL2_1, EL2_2, and EL2_3 may be separated from each other by the separator SPR. In an embodiment, one light emitting unit, for example, the light emitting unit UT11 arranged in the first row and the first column, may include three light emitting parts EP1, EP2, and EP3. Accordingly, one light emitting unit may include three cathodes EL2_1, EL2_2, and EL2_3 (hereinafter, referred to as first, second, and third cathodes), three pixel drivers PC1, PC2, and PC3 (hereinafter, referred to as first, second, and third pixel drivers), and three connection wirings CN1, CN2, and CN3, however, this is an example. According to an embodiment, the number and arrangement of the light emitting units may be designed in various ways and should not be particularly limited.

The first, second, and third pixel drivers PC1, PC2, and PC3 may be respectively connected to the light emitting devices LD (refer to FIG. 2A or 2B) forming the first, second, and third light emitting parts EP1, EP2, and EP3. In the disclosure, the expression that a component A is connected to a component B may mean not only a case where the component A is directly and physically connected to the component B, but also a case where the component A is electrically connected to the component B.

The first, second, and third pixel drivers PC1, PC2, and PC3 may be sequentially arranged in the first direction DR1. The arrangement positions of the first, second, and third pixel drivers PC1, PC2, and PC3 may be designed independently from positions and shapes of the first, second, and third light emitting parts EP1, EP2, and EP3.

As an example, the first, second, and third pixel drivers PC1, PC2, and PC3 may be placed at positions different from the areas divided by the separator SPR, for example, positions at which the first, second, and third cathodes EL2_1, EL2_2, and EL2_3 are placed, or may be designed to have shapes and sizes different from the shapes and sizes of the first, second, and third cathodes EL2_1, EL2_2, and EL2_3. According to an embodiment, the first, second, and third pixel drivers PC1, PC2, and PC3 may be placed to respectively overlap the positions at which the first, second, and third light emitting parts EP1, EP2, and EP3 are placed and may be designed to have shapes and sizes similar to those of the areas divided by the separator, for example, shapes and sizes of the first, second, and third cathodes EL2_1, EL2_2, and EL2_3.

In an embodiment, each of the first, second, and third pixel drivers PC1, PC2, and PC3 may have a rectangular shape, the first, second, and third light emitting parts EP1, EP2, and EP3 may be arranged in different arrangements, and the first, second, and third cathodes EL2_1, EL2_2, and EL2_3 may be placed at positions overlapping the first, second, and third light emitting parts EP1, EP2, and EP3 and may have an atypical shape.

Accordingly, as shown in FIG. 4B, the first pixel driver PC1 may be placed at a position overlapping the first light emitting part EP1, the second light emitting part EP2, and a portion of another light emitting unit adjacent thereto. The second pixel driver PC2 may be placed at a position overlapping the first light emitting part EP1, the second light emitting part EP2, and the third light emitting part EP3. The third pixel driver PC3 may be placed at a position overlapping the third light emitting part EP3, however, these are examples. According to an embodiment, the positions of the first, second, and third pixel drivers PC1, PC2, and PC3 may be designed to have various shapes and arrangements independently of the light emitting parts EP1, EP2, and EP3 and should not be particularly limited.

The connection wiring CN may be provided in plural, and the connection wirings CN may be arranged spaced apart from each other. Each of the connection wirings CN may connect the pixel driver PC or PC-1 and the light emitting device LD (refer to FIG. 2A or 2B). In detail, each of the connection wirings CN may correspond to the node (refer to N4 of FIG. 2A or N2 of FIG. 2B) at which the light emitting device LD (refer to FIG. 2A or 2B) is connected to the pixel driver PC or PC-1.

The connection wiring CN may include a first connection part CE (hereinafter, referred to as an emission connection part) and a second connection part CD (hereinafter, referred to as a driver connection part). The emission connection part CE may be provided at one side or a side of the connection wiring CN, and the driver connection part CD may be provided at the other side of the connection wiring CN.

The driver connection part CD may be a portion of the connection wiring CN, which is connected to the pixel driver PC. In an embodiment, the driver connection part CD may be connected to one electrode of a transistor forming the pixel driver PC. In detail, the driver connection part CD may be connected to a drain of the sixth transistor T6 shown in FIG. 2A or the drain of the first transistor T1 shown in FIG. 2B. Accordingly, a position of the driver connection part CD may correspond to a position of a transistor (refer to TR of FIG. 5A) of the pixel driver PC, which is physically connected to the connection wiring CN.

The emission connection part CE may be a portion of the connection wiring CN, which is connected to the light emitting device LD (refer to FIG. 2A or 2B). In an embodiment, the emission connection part CE may be a portion of the connection wiring CN, which is in direct contact with the cathodes EL2_1, EL2_2, and EL2_3, or a portion of the connection wiring CN, which is in direct contact with a separate electrode or a conductive pattern electrically connected to the cathodes EL2_1, EL2_2, and EL2_3, to be electrically connected to the cathodes EL2_1, EL2_2, and EL2_3.

In an embodiment, the connection wirings CN may include first connection wirings CN1, second connection wirings CN2, and third connection wirings CN3. The emission connection part CE may be provided for each connection wire CN, and the emission connection parts CE may include first emission connection parts CE1, second emission connection parts CE2, and third emission connection parts CE3. The driver connection part CD may be provided for each connection wire CN, and the driver connection parts CD may include first driver connection parts CD1, second driver connection parts CD2, and third driver connection parts CD3. The light emitting unit may include first, second, and third connection wirings CN1, CN2, and CN3. The first connection wiring CN1 may connect the light emitting device LD (refer to FIG. 2A or 2B), which forms the first light emitting part EP1, to the first pixel driver PC1, the second connection wiring CN2 may connect the light emitting device LD (refer to FIG. 2A or 2B), which forms the second light emitting part EP2, to the second pixel driver PC2, and the third connection wiring CN3 may connect the light emitting device LD (refer to FIG. 2A or 2B), which forms the third light emitting part EP3, to the third pixel driver PC3.

In detail, the first, second, and third connection wirings CN1, CN2, and CN3 may connect the first, second, and third cathodes EL2_1, EL2_2, and EL2_3 to the first, second, and third pixel drivers PC1, PC2, and PC3, respectively. The first connection wiring CN1 may include a first driver connection part CD1 connected to the first pixel driver PC1 and a first emission connection part CE1 connected to the first cathode EL2_1. The second connection wiring CN2 may include a second driver connection part CD2 connected to the second pixel driver PC2 and a second emission connection part CE2 connected to the second cathode EL2_2. The third connection wiring CN3 may include a third driver connection part CD3 connected to the third pixel driver PC3 and a third emission connection part CE3 connected to the third cathode EL2_3.

The first, second, and third driver connection parts CD1, CD2, and CD3 may be arranged in the first direction DR1. As described above, positions of the first, second, and third driver connection parts CD1, CD2, and CD3 may respectively correspond to positions of connection transistors forming the first, second, and third pixel drivers PC1, PC2, and PC3. In one pixel, the connection transistor may include the connection node at which the pixel driver PC is connected to the light emitting device LD (refer to FIG. 2A or 2B) as its electrode. As an example, the connection transistor may correspond to the sixth transistor T6 of FIG. 2A or the first transistor T1 of FIG. 2B. According to the disclosure, as the pixel driver is designed identically for all pixels regardless of the shape or size of the light emitting part and emission colors, a manufacturing process of the display panel (refer to FIG. 3A) may be simplified, and a manufacturing cost of the display device DD may be reduced.

In an embodiment, the first, second, and third emission connection parts CE1, CE2, and CE3 may be defined at positions that do not overlap the light emitting parts EP1, EP2, and EP3 when viewed in the plan view. Each of the emission connection parts CE1, CE2, and CE3 may be provided at the position that does not overlap the light emitting opening OP-E (refer to FIG. 5A) since the emission connection part CE of the connection wiring CN is connected to the light emitting device LD (refer to FIG. 2A or 2B) and a tip part TIP (refer to FIG. 5A) is defined in the emission connection part CE of the connection wiring CN. For example, the emission connection parts CE1, CE2, and CE3 may be placed at the positions spaced apart from the light emitting parts EP1, EP2, and EP3 in the cathodes EL2_1, EL2_2, and EL2_3, and the cathodes EL2_1, EL2_2, and EL2_3 may include portions protruding from the light emitting parts EP1, EP2, and EP3, respectively, when viewed in the plan view, to be connected to the connection wirings CN1, CN2, and CN3 at positions where the emission connection parts CE1, CE2, and CE3 are placed.

As an example, the first cathode EL2_1 may include a protruding portion protruded from the first light emitting part EP1 at the position that does not overlap the first light emitting part EP1 to be connected to the first connection wiring CN1 at the position where the first emission connection part CE1 is placed, and the emission connection part CE1 may be provided in the protruding portion. Accordingly, the first emission connection part CE1 may be connected to the first connection wiring CN1 without reducing a light emitting area of the first light emitting part EP1.

In the first pixel driver PC1, the first driver connection part CD1 that is the position connected to the connection transistor TR (refer to FIG. 5A) may be defined at a position that does not overlap the first light emitting part EP1 when viewed in the plan view. According to an embodiment, as the first connection wiring CN1 is disposed in the first light emitting part EP1, the first cathode EL2_1 may be readily connected to the first pixel driver PC 1.

In the third pixel driver PC3, the third driver connection part CD3 that is the position connected to the connection transistor TR (refer to FIG. 5A) may be defined at a position that does not overlap the third emission connection part CE3 when viewed in the plan view and may be placed at a position overlapping the third light emitting part EP3. According to an embodiment, as the third cathode EL2_3 is connected to the third pixel driver PC3 via the third connection wiring CN3, the third pixel driver PC3 may be readily connected to the third cathode EL2_3 even though the third driver connection part CD3 overlaps the third light emitting part EP3 when viewed in the plan view. Accordingly, restrictions on the design of the third pixel driver PC3 due to the position or shape of the third light emitting part EP3 may be reduced, and the degree of freedom in circuit design may be improved.

A third emission connection part CE3a disposed in the light emitting unit UT11 arranged in the first row and the first column may be disposed spaced apart from a corresponding third light emitting part EP3 in the second direction DR2, and a third emission connection part CE3b disposed in the light emitting unit UT12 arranged in the first row and the second column may be disposed spaced apart from a corresponding third light emitting part EP3 in a direction opposite to the second direction DR2.

As shown in FIG. 4B, the first to third connection wirings CN1a, CN2a, and CN3a disposed in the light emitting unit UT11 arranged in the first row and the first column may include the first to third emission connection parts CE1a, CE2a, and CE3a and the first to third driver connection parts CD1a, CD2a, and CD3a, respectively. The first to third connection wirings CN1b, CN2b, and CN3b disposed in the light emitting unit UT12 arranged in the first row and the second column may also include the first to third emission connection parts CE1b, CE2b, and CE3b and the first to third driver connection parts CD1b, CD2b, and CD3b, respectively. A first emission connection part CE1a disposed in the light emitting unit UT11 arranged in the first row and the first column and a first emission connection part CE1b disposed in the light emitting unit UT12 arranged in the first row and the second column may be disposed spaced apart from each other in the first direction DR1 with the third emission connection part CE3a, which is disposed in the light emitting unit UT11 arranged in the first row and the first column, interposed therebetween. A second emission connection part CE2b disposed in the light emitting unit UT12 arranged in the first row and the second column and a second emission connection part disposed in the light emitting unit adjacent thereto, for example, the light emitting unit arranged in the first row and the third column, which has the same shape and arrangement as those of the light emitting unit UT11 arranged in the first row and the first column, may be disposed spaced apart from each other in the first direction DR1 with the third emission connection part CE3b, which is disposed in the light emitting unit UT12 arranged in the first row and the second column, interposed therebetween.

The shape and the arrangement of the first and second light emitting parts constituting the light emitting unit UT11 may be axisymmetric with that of the first and second light emitting parts constituting the light emitting unit UT12 with respect to the axis parallel to the second direction DR2. The shape and the arrangement of the third light emitting part constituting the light emitting unit UT11 may be axisymmetric with that of the third light emitting part constituting the light emitting unit UT12 with respect to the axis parallel to the first direction DR1 (or, symmetrical vertically based on the second direction DR2). Due to the relationship of the light emitting units UT11 and UT12 arranged in the first row, the light emitting units UT21 and UT22 arranged in the second row may include the light emitting parts obtained by shifting the light emitting units UT11 and UT12 arranged in the first row in the first direction DR1. For example, the light emitting unit UT21 arranged in the second row and the first column may include the light emitting parts having the same shape as that of the light emitting parts included in the light emitting unit UT12 arranged in the first row and the second column, and the light emitting unit UT22 arranged in the second row and the second column may include the light emitting parts having the same shape as that of the light emitting parts included in the light emitting unit UT11 arranged in the first row and the first column.

Accordingly, connection wirings CN-c arranged in the light emitting unit UT21 arranged in the second row and the first column may have the same shape and arrangement as those of connection wirings CN1b, CN2b, and CN3b arranged in the light emitting unit UT12 arranged in the first row and the second column. Similarly, connection wirings CN-d arranged in the light emitting unit UT22 arranged in the second row and the second column may have the same shape and arrangement as those of connection wirings CN1a, CN2a, and CN3a arranged in the light emitting unit UT11 arranged in the first row and the first column.

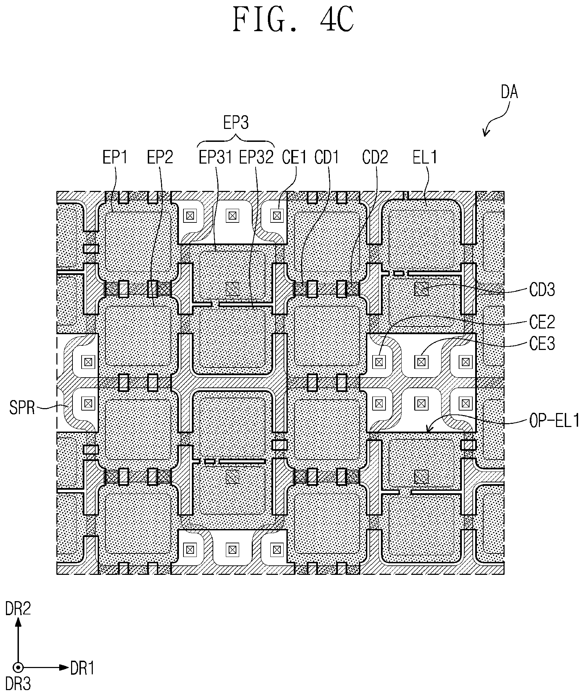

Referring to FIG. 4C, the first electrode EL1 (hereinafter, referred to as the anode) may be commonly disposed in the light emitting parts EP1, EP2, and EP3. For example, the anode EL1 may have an integral shape and may overlap the light emitting parts EP1, EP2, and EP3 or the separator SPR. As described above, the first driving voltage VDD (refer to FIG. 2A) may be applied to the anode EL1, and a common voltage may be applied to all the light emitting parts EP1, EP2, and EP3. The anode EL1 may be connected to the first driving voltage line VDL (refer to FIG. 2A) providing the first driving voltage VDD (refer to FIG. 2A) in the peripheral area NDA or may be connected to the first driving voltage line VDL (refer to FIG. 2A) in the display area DA, and it should not be limited thereto or thereby.

Openings OP-EL1 may be defined through the anode EL1, and the openings OP-EL1 may penetrate through the anode EL1. The openings OP-EL1 may be defined not to overlap the light emitting parts EP1, EP2, and EP3 and may be defined to overlap the separator SPR. The openings OP-EL1 may facilitate a discharge of a gas generated from an organic layer disposed under or below the anode EL1, for example, a sixth insulating layer 60 (refer to FIG. 5A). Accordingly, the gas from the organic layer may be sufficiently discharged in a manufacturing process of the display panel DP (refer to FIG. 1), and, deterioration of the light emitting device LD (refer to FIG. 2A or 2B), which is caused by the gas generated from the organic layer, may be improved.

According to the disclosure, different from the light emitting devices in which the cathode overlaps a corresponding connection transistor of the pixel driver when viewed in the plan view, the light emitting device including the cathode having the shape that does not overlap the connection transistor of the pixel driver may be readily connected to the pixel driver since the display panel may further include the connection wiring. According to the disclosure, as the display panel may further include the connection wiring, the light emitting device may be stably connected to the pixel driver by changing only the shape of the cathode without changing the design of the light emitting parts. Accordingly, the influence of the arrangement or shape of the light emitting parts on the connection between the light emitting device and the pixel driver may be reduced, a design freedom for the arrangement of the pixel driver may be improved, and deterioration in aperture ratio of the light emitting part may be prevented.

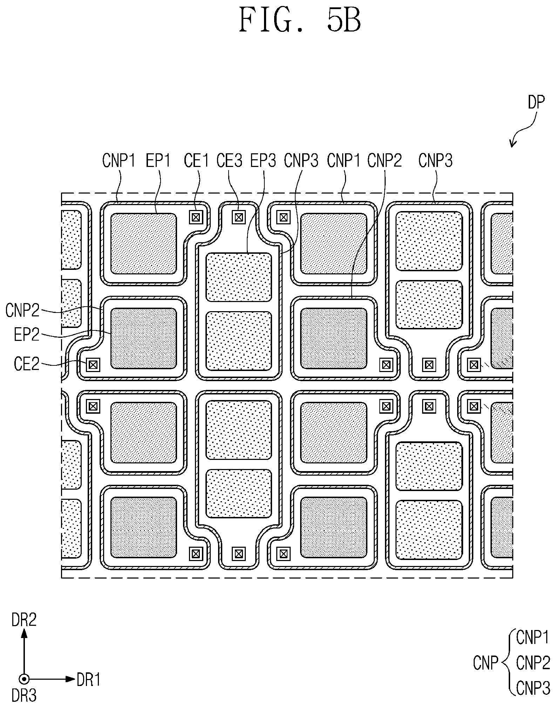

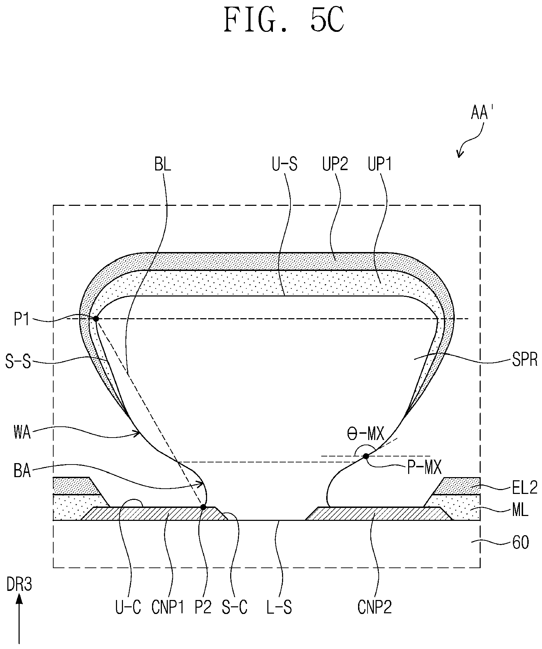

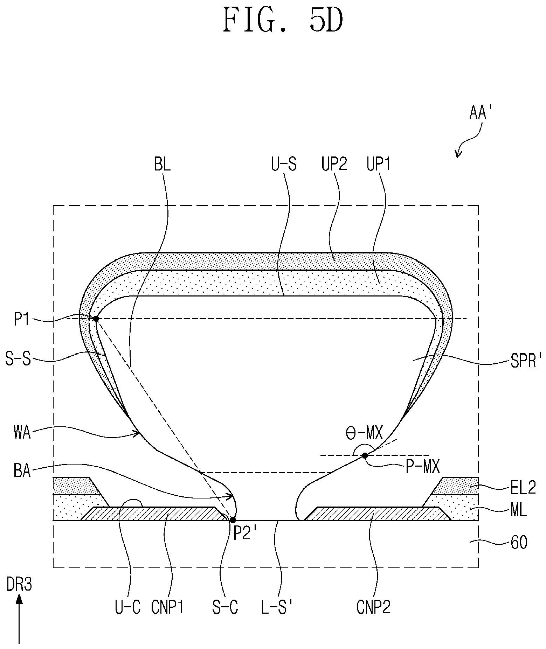

FIG. 5A is an enlarged schematic cross-sectional view of the display panel DP taken along line I-I' of FIG. 4B according to an embodiment. FIG. 5B is an enlarged schematic plan view of a number of components of the display panel DP according to an embodiment. FIGS. 5C and 5D are enlarged schematic cross-sectional views of an area AA' of FIG. 5A according to embodiments.

Referring to FIG. 5A, the display panel DP may include a base layer BS, a driving device layer DDL, a light emitting device layer LDL, and a sensing layer ISL. The driving device layer DDL may include insulating layers 10, 20, 30, 40, and 50 disposed on the base layer BS and conductive patterns and semiconductor patterns, which are disposed between the insulating layers. The conductive patterns and the semiconductor patterns disposed between the insulating layers may form the pixel driver PC. For the convenience of explanation, FIG. 5A shows a schematic cross-section of a portion of an area in which one light emitting part is disposed.

The base layer BS may provide a base surface on which the pixel driver PC is disposed. The base layer BS may be a rigid substrate or a flexible substrate that is bendable, foldable, or rollable. The base layer BS may be a glass substrate, a metal substrate, or a polymer substrate, however, it should not be limited thereto or thereby. According to an embodiment, the base layer BS may be an inorganic layer, an organic layer, or a composite material layer.

The base layer BS may have a multi-layer structure. For instance, the base layer BS may include a first polymer resin layer, a silicon oxide (SiOₓ) layer disposed on the first polymer resin layer, an amorphous silicon (a-Si) layer disposed on the silicon oxide layer, and a second polymer resin layer disposed on the amorphous silicon (a-Si) layer. The silicon oxide (SiOₓ) layer and the amorphous silicon (a-Si) layer may be referred to as a base barrier layer.

Each of the first and second polymer resin layers may include a polyimide-based resin. Each of the first and second polymer resin layers may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, and a perylene-based resin. In the disclosure, the term "X-based resin", as used herein, refers to the resin that may include a functional group of X.

The display panel DP may include insulating layers, conductive layers, and semiconductor layers, which are disposed on the base layer BS and each of which are formed through coating and deposition processes. The insulating layers, the conductive layers, and the semiconductor layers may be selectively patterned through several photolithography processes, and thus, a hole may be defined through the insulating layers or the semiconductor pattern, the conductive pattern, and the signal line may be formed.

The driving device layer DDL may include first, second, third, fourth, and fifth insulating layers 10, 20, 30, 40, and 50, which may be sequentially stacked on each other on the base layer BS, and the pixel driver PC. FIG. 5A shows one transistor TR and two capacitors C1 and C2 of the pixel driver PC. The transistor TR may correspond to a transistor connected to the light emitting device LD via the connection wiring CN, for example, the connection transistor connected to the node (the fourth node N4 of FIG. 2A or the second node N2 of FIG. 2B) corresponding to a cathode EL2 of the light emitting device LD. In detail, the transistor TR may correspond to the sixth transistor T6 of FIG. 2A or the first transistor T1 of FIG. 2B. Although not shown in figures, other transistors forming the pixel driver PC may have substantially the same structure as that of the transistor TR (hereinafter, referred to as the connection transistor) shown in FIG. 5A, however, this is an example. According to an embodiment, other transistors forming the pixel driver PC may have a structure different from the connection transistor TR and should not be particularly limited.

The first insulating layer 10 may be disposed on the base layer BS. The first insulating layer 10 may be an inorganic layer and/or an organic layer and may have a single-layer or multi-layer structure. The first insulating layer 10 may include at least one of aluminum oxide, titanium oxide, silicon oxide, silicon nitride, silicon oxynitride, zirconium oxide, and hafnium oxide. In an embodiment, the first insulating layer 10 may have a single-layer structure of a silicon oxide layer. Insulating layers described later may be an inorganic layer and/or an organic layer and may have a single-layer or multi-layer structure. The inorganic layer may include at least one of the above-mentioned materials, however, it should not be limited thereto or thereby.

The first insulating layer 10 may cover a bottom conductive layer BML. For example, the display panel may further include the bottom conductive layer BML disposed under or below the connection transistor TR and overlapping the connection transistor TR. The bottom conductive layer BML may prevent an electric potential caused by a polarization phenomenon of the base layer BS from exerting influence on the connection transistor TR. The bottom conductive layer BML may block a light incident into the connection transistor TR from a lower side of the bottom conductive layer BML (i.e. from the base layer BS side). At least one of an inorganic barrier layer and a buffer layer may be further disposed between the bottom conductive layer BML and the base layer BS.

The bottom conductive layer BML may include a reflective metal material. As an example, the bottom conductive layer BML may include titanium (Ti), molybdenum (Mo), an alloy including molybdenum (Mo), aluminum (Al), an alloy including aluminum (Al), aluminum nitride (AlN), tungsten (W), tungsten nitride (WN), and copper (Cu).

In an embodiment, the bottom conductive layer BML may be connected to a source (or the source area SR of the semiconductor pattern SP) of the connection transistor TR via a source electrode pattern W1. The bottom conductive layer BML may be synchronized with the source of the connection transistor TR, however, this is an example. According to an embodiment, the bottom conductive layer BML may be connected to and synchronized with a gate (or a gate electrode GE) of the connection transistor TR. According to an embodiment, the bottom conductive layer BML may be connected to another electrode to independently receive a constant voltage or a pulse signal. According to an embodiment, the bottom conductive layer BML may be provided in an isolated form isolated from other conductive patterns. The bottom conductive layer BML may be provided in a variety of shapes and should not be particularly limited.

The connection transistor TR may be disposed on the first insulating layer 10. The connection transistor TR may include the semiconductor pattern SP and the gate electrode GE. The semiconductor pattern SP may be disposed on the first insulating layer 10. The semiconductor pattern SP may include an oxide semiconductor. As an example, the oxide semiconductor may include a transparent conductive oxide (TCO), such as indium tin oxide (ITO), indium zinc oxide (IZO), indium gallium zinc oxide (IGZO), zinc oxide (ZnO), indium oxide (In₂O₃), or the like, however, the material for the semiconductor pattern SP should not be limited thereto or thereby. As an example, the semiconductor pattern may include amorphous silicon, low temperature polycrystalline silicon, or polycrystalline silicon.

The second insulating layer 20 may commonly overlap the pixels and may cover the semiconductor pattern SP. The second insulating layer 20 may be an inorganic layer and/or an organic layer and may have a single-layer or multi-layer structure. The second insulating layer 20 may include at least one of aluminum oxide, titanium oxide, silicon oxide, silicon nitride, silicon oxynitride, zirconium oxide, and hafnium oxide. In an embodiment, the second insulating layer 20 may have a single-layer structure of a silicon oxide layer.

The semiconductor pattern SP may include the source area SR, a drain area DR, and an active area AR (or a channel area) distinguished from each other depending on a degree of conductivity. The active area AR may overlap the gate electrode GE when viewed in the plan view. The source area SR and the drain area DR may be spaced apart from each other with the active area AR interposed therebetween. In case that the semiconductor pattern SP is the oxide semiconductor, each of the source area SR and the drain area DR may be a reduced area. Accordingly, the source area SR and the drain area DR may have a relatively high content of reduced metal compared with the active area AR. According to an embodiment, in case that the semiconductor pattern SP is the polycrystalline silicon, each of the source area SR and the drain area DR may be a highly doped area.

The source area SR and the drain area DR may have a relatively high conductivity compared with the active area AR. The source area SR may correspond to a source electrode of the connection transistor TR, and the drain area DR may correspond to a drain electrode of the connection transistor TR. As shown in FIG. 5A, conductive patterns may include the source electrode pattern W1 and a drain electrode pattern W2, and the source electrode pattern W1 and the drain electrode pattern W2 may be connected to the source area SR and the drain area DR of the connection transistor TR, respectively. In detail, each of the source electrode pattern W1 and the drain electrode pattern W2, which are separated from each other, may correspond to one of the lines forming the pixel driver PC, however, it should not be limited thereto or thereby.

The gate electrode GE may be disposed on the second insulating layer 20. The gate electrode GE may correspond to the gate of the connection transistor TR. The gate electrode GE may be disposed on or over the semiconductor pattern SP, however, this is an example. According to an embodiment, the gate electrode GE may be disposed under or below the semiconductor pattern SP, and it should not be particularly limited.

The gate electrode GE may include titanium (Ti), silver (Ag), molybdenum (Mo), aluminum (Al), aluminum nitride (AlN), tungsten (W), tungsten nitride (WN), copper (Cu), or an alloy thereof, however, it should not be particularly limited.

Among the conductive patterns W1, W2, CPE1, CPE2, and CPE3, a first capacitor electrode CPE1 and a second capacitor electrode CPE2 may form the first capacitor C1. The first capacitor electrode CPE1 and the second capacitor electrode CPE2 may be spaced apart from each other with the first insulating layer 10 and the second insulating layer 20 interposed therebetween.

According to an embodiment, the first capacitor electrode CPE1 and the bottom conductive layer BML may be integral with each other. The second capacitor electrode CPE2 may be integral with the gate electrode GE.

A third capacitor electrode CPE3 may be disposed on the third insulating layer 30. The third capacitor electrode CPE3 may be spaced apart from the second capacitor electrode CPE2 with the third insulating layer 30 interposed therebetween and may overlap the second capacitor electrode CPE2. The third capacitor electrode CPE3 and the second capacitor electrode CPE2 may form the second capacitor C2.

The fourth insulating layer 40 may be disposed on the third capacitor electrode CPE3.

The source electrode pattern W1 and the drain electrode pattern W2 may be disposed on the fourth insulating layer 40. The source electrode pattern W1 may be connected to the source area SR of the connection transistor TR via a first contact hole CNT1, and the source electrode pattern W1 and the source area SR of the semiconductor pattern SP may serve as the source of the connection transistor TR. The drain electrode pattern W2 may be connected to the drain area DR of the connection transistor TR via a second contact hole CNT2, and the drain electrode pattern W2 and the drain area DR of the semiconductor pattern SP may serve as the drain of the connection transistor TR.

The fifth insulating layer 50 may be disposed on the source electrode pattern W1 and the drain electrode pattern W2. The connection wiring CN may be disposed on the fifth insulating layer 50. The connection wiring CN may connect the connection transistor TR to the light emitting device LD. The connection wiring CN may be a connection node that connects the pixel driver PC to the light emitting device LD. For example, the connection wiring CN may correspond to the fourth node N4 shown in FIG. 2A or may correspond to the second node N2 shown in FIG. 2B, however, this is an example. The connection wiring CN may be defined as a connection node connected to various components of the pixel driver PC according to the design of the pixel driver PC as long as the connection wiring CN is connected to the light emitting device LD, and it should not be particularly limited.

The connection wiring CN may have a three-layer structure. In detail, the connection wiring CN may include a first layer L1, a second layer L2, and a third layer L3, which may be sequentially stacked on each other in a third direction DR3.

Each of the first and third layers L1 and L3 may have a relatively thinner thickness than that of the second layer L2. The first and third layers L1 and L3 may include the same material or a similar material as each other, and the second layer L2 may include a material different from that of the first and third layers L1 and L3. The second layer L2 may have an etch rate higher than an etch rate of each of the first and third layers L1 and L3. For example, the second layer L2 may include a material having an etch selectivity with respect to each of the first and third layers L1 and L3. As an example, each of the first and third layers L1 and L3 may include titanium (Ti), and the second layer L2 may include aluminum (Al). However, the materials for the first, second, and third layers L1, L2, and L3 should not be particularly limited.

A side surface of the third layer L3 may protrude outward from a side surface of the second layer L2. For example, the side surface of the second layer L2 may be disposed inside the side surface of the third layer L3 and may have an undercut shape or an overhang structure. The tip part TIP of the emission connection part CE may be defined by a portion of the third layer L3, which is protruded outward from the second layer L2.

The sixth insulating layer 60 may be disposed between the driving device layer DDL and the light emitting device layer LDL. The sixth insulating layer 60 may be disposed on the fifth insulating layer 50 and may cover the connection wiring CN. Each of the fifth insulating layer 50 and the sixth insulating layer 60 may be an organic layer. As an example, each of the fifth insulating layer 50 and the sixth insulating layer 60 may include benzocyclobutene (BCB), hexamethyldisiloxane (HMDSO), a general-purpose polymer such as polystyrene (PS), a polymer derivative having a phenolic group, an acrylic-based polymer such as polymethylmethacrylate (PMMA), an imide-based polymer such as polyimide, an aryl ether-based polymer, an amide-based polymer, a fluorine-based polymer, a p-xylene-based polymer, a vinyl alcohol-based polymer, or blends thereof.

The sixth insulating layer 60 may be provided with a first contact opening OP-C1 defined therethrough to expose at least a portion of the connection wiring CN. In detail, the side surface of the third layer L3 in which the tip part TIP is defined and the side surface of each of the first and second layers L1 and L2 adjacent to the side surface of the third layer L3 may be exposed without being covered by the sixth insulating layer 60.

The connection wiring CN may be connected to the connection transistor TR after penetrating through the fifth insulating layer 50 and may be connected to the light emitting device LD of the light emitting device layer LDL through the portion thereof exposed without being covered by the sixth insulating layer 60. For example, the connection wiring CN may connect the connection transistor TR to the light emitting device LD. This will be described in detail later.

The light emitting device layer LDL may be disposed on the sixth insulating layer 60. The light emitting device layer LDL may include a seventh insulating layer 70 (or a pixel definition layer) and the light emitting device LD. According to an embodiment, the sixth insulating layer 60 may be omitted from the display panel DP or may be provided in plural, and it should not be particularly limited.

The seventh insulating layer 70 may be an organic layer. As an example, the seventh insulating layer 70 may include benzocyclobutene (BCB), hexamethyldisiloxane (HMDSO), a general-purpose polymer such as polystyrene (PS), a polymer derivative having a phenolic group, an acrylic-based polymer such as polymethylmethacrylate (PMMA), an imide-based polymer such as polyimide, an aryl ether-based polymer, an amide-based polymer, a fluorine-based polymer, a p-xylene-based polymer, a vinyl alcohol-based polymer, or blends thereof.

The seventh insulating layer 70 may have a light absorbing property. For example, the seventh insulating layer 70 may have a black color. The seventh insulating layer 70 may include a black coloring agent. The black coloring agent may include a black dye or a black pigment. The black coloring agent may include carbon black, a metal material such as chromium, or an oxide thereof. The seventh insulating layer 70 may correspond to a light blocking pattern having a light blocking property.

The seventh insulating layer 70 may be provided with an opening OP-E (hereinafter, referred to as a light emitting opening) defined therethrough. The light emitting opening OP-E may be provided in plural, and the light emitting openings OP-E may respectively correspond to the light emitting devices LD. All components of the light emitting device LD may overlap each other in the light emitting opening OP-E, and the light emitting opening OP-E may correspond to an area where the light emitted from the light emitting device LD is substantially displayed. Accordingly, the shape of the light emitting part EP (refer to FIG. 3A) may substantially correspond to the shape of the light emitting opening OP-E when viewed in the plan view.

In an embodiment, a second contact opening OP-C2 corresponding to the first contact opening OP-C1 may be defined through the seventh insulating layer 70. The second contact opening OP-C2 may be spaced apart from the light emitting opening OP-E. The second contact opening OP-C2 may have a size equal to or greater than a size of the first contact opening OP-C1 when viewed in the plan view. The side surface of the third layer L3 in which the tip part TIP is defined and the side surface of each of the first and second layers L1 and L2 may be exposed without being covered by the seventh insulating layer 70.

The light emitting device LD may include the first electrode EL1, an intermediate layer ML, and the second electrode EL2. The first electrode EL1 may be a semi-transmissive electrode, a transmissive electrode, or a reflective electrode. According to an embodiment, the first electrode EL1 may include a reflective layer formed of silver (Ag), magnesium (Mg), aluminum (Al), platinum (Pt), palladium (Pd), gold (Au), nickel (Ni), neodymium (Nd), iridium (Ir), chromium (Cr), or compounds thereof and a transparent or semi-transparent electrode layer formed on the reflective layer. The transparent or semi-transparent electrode layer may include at least one selected from the group consisting of indium tin oxide (ITO), indium zinc oxide (IZO), indium gallium zinc oxide (IGZO), zinc oxide (ZnO), indium oxide (In₂O₃), and aluminum-doped zinc oxide (AZO). For instance, the first electrode EL1 may have a stack structure of ITO/Ag/ITO.

In an embodiment, the first electrode EL1 may be the anode of the light emitting device LD. For example, the first electrode EL1 may be connected to the first driving voltage line VDL (refer to FIG. 2A) and may receive the first power supply voltage VDD (refer to FIG. 2A). The first electrode EL1 may be connected to the first driving voltage line VDL in the display area DA (refer to FIG. 3 A) or may be connected to the first driving voltage line VDL in the peripheral area NDA (refer to FIG. 3A). In the case where the first electrode EL1 is connected to the first driving voltage line VDL in the peripheral area NDA (refer to FIG. 3A), the first driving voltage line VDL (refer to FIG. 2A) may be disposed in the peripheral area NDA, and the first electrode EL1 may extend to the peripheral area NDA (refer to FIG. 3A).

In an embodiment, the first electrode EL1 overlaps the light emitting opening OP-E and does not overlap the separator SPR, however, it should not be limited thereto or thereby. As described above, the first electrodes of each pixel may have an integral shape and may have a mesh or lattice shape in which openings are defined in a number of areas. For example, the first electrode EL1 may have a variety of shapes as long as the light emitting devices receive the same first power supply voltage VDD through their first electrodes EL1, however, it should not be limited thereto or thereby.

The intermediate layer ML may be disposed between the first electrode EL1 and the second electrode EL2. The intermediate layer ML may include a light emitting layer EML and a functional layer FNL, however, this is an example. The light emitting device LD may include the intermediate layer ML with various structures and should not be particularly limited. As an example, the functional layer FNL may include layers or may include two or more layers spaced apart from each other with the light emitting layer EML interposed therebetween. According to an embodiment, the functional layer FNL may be omitted.

The light emitting layer EML may absorb an energy corresponding to a difference in electric potential between the first electrode EL1 and the second electrode EL2 and may emit the light. The light emitting layer EML may include an organic light emitting material, however, it should not be limited thereto or thereby. According to an embodiment, the light emitting layer EML may include an inorganic light emitting material or may include a layer obtained by mixing the organic light emitting material with the inorganic light emitting material.

The light emitting layer EML may be disposed to overlap the light emitting opening OP-E. In an embodiment, the light emitting layer EML may be formed separately in each of the pixels. In the case where the light emitting layer EML is formed separately in each of the light emitting parts EP (refer to FIG. 3A), the light emitting layer EML may emit the light having at least one of blue, red, and green colors, however, it should not be limited thereto or thereby. According to an embodiment, the light emitting layer EML may have an integral shape to be commonly disposed in the light emitting parts EP (refer to FIG. 3A) adjacent to each other. The light emitting layer EML may provide a blue light or a white light. The light emitting layer EML may have substantially the same shape as that of the functional layer FNL and may be integral with the functional layer FNL without a layer boundary with respect to the functional layer FNL, so that the intermediate layer ML including the light emitting layer EML and the functional layer FNL integrally formed may be provided.

The functional layer FNL may be disposed between the first electrode EL1 and the second electrode EL2. In detail, the functional layer FNL may be disposed between the first electrode EL1 and the light emitting layer EML or may be disposed between the second electrode EL2 and the light emitting layer EML. According to an embodiment, the functional layer FNL may be disposed between the first electrode EL1 and the light emitting layer EML and between the second electrode EL2 and the light emitting layer EML. In an embodiment, the light emitting layer EML may be inserted into the functional layer FNL, however, this is an example. According to an embodiment, the functional layer FNL may include a layer disposed between the light emitting layer EML and the first electrode EL1 and/or a layer disposed between the light emitting layer EML and the second electrode EL2, and each of the layers may be provided in plural. However, they should not be limited thereto or thereby.

The functional layer FNL may control a movement of electric charges. The functional layer FNL may include a hole injection/transport material and/or an electron injection/transport material. The functional layer FNL may include at least one of an electron block layer, a hole transport layer, a hole injection layer, a hole block layer, an electron transport layer, an electron injection layer, and an electric charge generating layer.

The second electrode EL2 may be disposed on the intermediate layer ML. As described above, the second electrode EL2 may be connected to the pixel driver PC via the fourth node N4 of FIG. 2A or the second node N2 of FIG. 2B. In an embodiment, the second electrode EL2 may be electrically connected to the connection transistor TR via the connection wiring CN.

The connection wiring CN may include the driver connection part CD and the emission connection part CE. For the convenience of explanation, FIG. 5A shows the driver connection part CD and the emission connection part CE, and a portion of the connection wiring CN connecting the driver connection part CD and the emission connection part CE is omitted.

The driver connection part CD of the connection wiring CN may be connected to the pixel driver PC and may be substantially connected to the connection transistor TR. In an embodiment, the driver connection part CD may be connected to the drain area DR of the semiconductor pattern SP via the drain electrode pattern W2 of the transistor TR after penetrating through the fifth insulating layer 50.

In an embodiment, the emission connection part CE may be defined in an area exposed through the first contact opening OP-C1 without being covered by the sixth insulating layer 60, and the second electrode EL2 may be directly in contact with the emission connection part CE. In detail, the second electrode EL2 may be directly in contact with the side surface of the second layer L2 exposed without being covered by the sixth insulating layer 60.

In an embodiment, conductive patterns CNP may be disposed on the sixth insulating layer 60. Each of the conductive patterns CNP may be disposed in a separation opening OP-S defined through the seventh insulating layer 70. The separation opening OP-S may be spaced apart from the light emitting opening OP-E.

As shown in FIG. 5B, the conductive patterns CNP may include first patterns CNP1, second patterns CNP2, and third patterns CNP3. Each of the first, second, and third patterns CNP1, CNP2, and CNP3 may have a closed-line shape or a line pattern when viewed in the plan view.

When viewed in the plan view, each of the first patterns CNP1 may surround a corresponding first light emitting part EP1 and the first emission connection part CE1 adjacent to the corresponding first light emitting part EP1, each of the second patterns CNP2 may surround a corresponding second light emitting part EP2 and the second emission connection part CE2 adjacent to the corresponding second light emitting part EP2, and each of the third patterns CNP3 may surround a corresponding third light emitting part EP3 and the third emission connection part CE3 adjacent to the corresponding third light emitting part EP3.

In an embodiment, the conductive patterns CNP may include a transparent conductive material. As an example, the conductive patterns CNP may include indium tin oxide (ITO), indium zinc oxide (IZO), indium tin zinc oxide (ITZO), indium gallium zinc oxide (IGZO), or the like within the scope of the disclosure. Each of the conductive patterns CNP may have a single-layer structure.

In an embodiment, the separator SPR may be disposed on the sixth insulating layer 60. The separator SPR may be disposed in the separation opening OP-S defined through the seventh insulating layer 70. The separator SPR may be disposed between patterns adjacent to each other among the first, second, and third patterns CNP1, CNP2, and CNP3 and may be in contact with the sixth insulating layer 60 exposed between the patterns adjacent to each other. The separator SPR may overlap a line pattern of each of the first, second, and third patterns CNP1, CNP2, and CNP3 when viewed in the plan view.

In an embodiment, the sixth insulating layer 60 may be referred to as a contact insulating layer (a first insulating layer in claims), and the seventh insulating layer 70 may be referred to as an upper insulating layer (a second insulating layer in claims) that is an insulating layer disposed on the contact insulating layer.

According to an embodiment, the separator SPR may be an organic layer. As an example, the separator SPR may include benzocyclobutene (BCB), hexamethyldisiloxane (HMDSO), a general-purpose polymer such as polystyrene (PS), a polymer derivative having a phenolic group, an acrylic-based polymer such as polymethylmethacrylate (PMMA), an imide-based polymer such as polyimide, an aryl ether-based polymer, an amide-based polymer, and a fluorine-based polymer, a p-xylene-based polymer, a vinyl alcohol-based polymer, or blends thereof.

The second electrode EL2 of each of the light emitting devices LD may be commonly formed using an open mask, but may be separated for each pixel by the separator SPR. The separator SPR may have a width that decreases going from an upper surface U-S (refer to FIG. 5C) to a lower surface L-S (refer to FIG. 5C), and thus, the second electrode EL2 may not be formed on at least a portion of a side surface S-S (refer to FIG. 5C) of the separator SPR and may have a disconnected shape even though a separate patterning process using a mask is not performed. Accordingly, the second electrode EL2 may be readily separated for each pixel.

As a degree of the decrease in the width of the separator SPR, which decreases going from the upper surface U-S (refer to FIG. 5C) to the lower surface L-S (refer to FIG. 5C), increases when viewed in a cross-section, a probability that the second electrode EL2 is separated near the side surface S-S (refer to FIG. 5C) of the separator SPR may increase. Accordingly, the electrodes of the light emitting device LD, which are connected to the pixel drivers PC of the pixels adjacent to each other, may not be separated from each other, and thus, a defective pixel may be prevented from occurring.

Referring to FIG. 5C, the separator SPR may include the lower surface L-S that is in contact with the contact insulating layer, for example, the sixth insulating layer 60, the upper surface U-S opposite to the lower surface L-S, and the side surface S-S connecting the lower surface L-S and the upper surface U-S. The lower surface L-S of the separator SPR may cover a portion of an upper surface U-C of each of the conductive patterns CNP1 and CNP2 and an outer side surface S-C of each of the conductive patterns CNP1 and CNP2.

According to an embodiment, the upper surface U-S of the separator SPR may be a convex surface that protrudes in a direction away from the lower surface L-S. A boundary between the upper surface U-S and the side surface S-S of the separator SPR may be defined as a point where the side surface S-S of the separator SPR has an interior angle of about 90 degrees with respect to the upper surface U-C of the conductive patterns CNP1 and CNP2. However, the shape of the upper surface U-S of the separator SPR should not be particularly limited, and the upper surface U-S of the separator SPR may be a plane extending in the first and second directions DR1 and DR2 (refer to FIG. 5B).

According to an embodiment, the separator SPR may include a bottleneck area BA and a wide area WA defined on an upper side of the bottleneck area BA when viewed in a cross-section perpendicular to the direction in which the separator SPR extends. When viewed in the cross-section, the boundary between the upper surface U-S and the side surface S-S of the separator SPR may be referred to as a first point P1, a point where the side surface S-S of the separator SPR is in contact with the upper surface U-C of the conductive patterns CNP may be referred to as a second point P2, and an imaginary line extending from the first point P1 to the second point P2 may be referred to as a reference line BL.

Referring to FIG. 5D, a separator SPR' may not cover an upper surface U-C and an outer side surface S-C of each of conductive patterns CNP1 and CNP2. For example, a side surface S-S of the separator SPR' may not be in contact with the conductive patterns CNP1 and CNP2. An entire portion of a lower surface L-S' of the separator SPR' may be in contact with a sixth insulating layer 60, and a second point P2' may be defined as a point where the side surface S-S of the separator SPR' is in contact with the sixth insulating layer 60. Hereinafter, details on the shape of the separator SPR described with reference to FIG. 5C may be applied to the separator SPR' of FIG. 5D.

The wide area WA may be defined as an area that protrudes in a direction outward from the reference line BL to the outside of the separator SPR, and the bottleneck area BA may be defined as an area recessed in a direction inward from the reference line BL to the inside of the separator SPR.

When viewed in the cross-section, a point where the side surface S-S of the separator SPR has a maximum interior angle θ-MX with respect to the upper surface U-C of the conductive patterns CNP1 and CNP2 may be referred to as a maximum point P-MX. The maximum interior angle θ-MX may be equal to or greater than about 130 degrees and equal to or smaller than about 170 degrees, however, it should not be limited thereto or thereby. The maximum interior angle θ-MX may vary depending on a material for the separator SPR or a condition of the patterning process for the separator SPR. The maximum interior angle θ-MX may be set to an angle appropriate to divide the second electrode EL2 according to a condition of the deposition process of the second electrode EL2.

According to the disclosure, as a lower portion of the separator SPR is greatly removed in the process of patterning the separator SPR, the side surface S-S of the separator SPR may include the bottleneck area BA when viewed in the cross-section. Accordingly, a probability that the second electrode EL2 is deposited on a portion of the side surface S-S of the separator SPR adjacent to the maximum point P-MX may decrease, and thus, the second electrode EL2 may be clearly separated for each pixel.

Different from an embodiment, according to a comparative example, the conductive pattern may not be disposed, and a lower surface of a preliminary separator, which is provided after being coated, may be entirely in contact with the sixth insulating layer 60 in a process of forming the separator. As the preliminary separator and the sixth insulating layer 60 include a polymer resin, the preliminary separator and the sixth insulating layer 60 may have a hydrophobic surface. For example, an adhesion between the preliminary separator and the sixth insulating layer 60 may be high.

On the other hand, according to an embodiment, the conductive patterns CNP may include the transparent conductive material, and thus, the conductive patterns CNP may have a hydrophilic surface. A portion of the lower surface of the preliminary separator having the hydrophobic surface may be in contact with the upper surface U-C of the conductive patterns CNP having the hydrophilic surface, and an adhesion between the preliminary separator and the conductive patterns CNP may be lower than the adhesion between the preliminary separator and the sixth insulating layer 60. Therefore, in case that the preliminary separator is patterned to form the separator SPR, an amount of removed preliminary separator may be greater than that in the comparative example, and the patterned separator SPR may be provided to have a shape in which the maximum interior angle θ-MX between the side surface S-S of the separator SPR and the upper surface U-C of the conductive patterns CNP is greater than that of the comparative example.

Since the second electrode EL2 is clearly separated for each pixel according to the disclosure, the defective pixel may be prevented from occurring, and a reliability of the display panel DP may be improved.

Separation patterns UP1 and UP2 may be disposed on the separator SPR. The separation patterns UP1 and UP2 may include a first separation pattern UP1 and a second separation pattern UP2.

The first separation pattern UP1 may include the same material or a similar material as that of the intermediate layer ML. The first separation pattern UP1 may be formed through the same process as the intermediate layer ML. For example, the first separation pattern UP1 may be formed in the manufacturing process of the intermediate layer ML.

The second separation pattern UP2 may include the same material or a similar material as that of the second electrode EL2. The second separation pattern UP2 may be formed through the same process as the second electrode EL2. For example, the second separation pattern UP2 may be formed in the manufacturing process of the second electrode EL2. When viewed in the plan view, the first and second separation patterns UP1 and UP2 may have substantially the same shape as that of the separator SPR.

As shown in FIG. 5C, the first and second separation patterns UP1 and UP2 may be deposited not only on the upper surface U-S but also a portion of the side surface S-S of the separator SPR. The first and second separation patterns UP1 and UP2 may not be disposed around the maximum point P-MX in the side surface S-S of the separator SPR. In detail, the first and second separation patterns UP1 and UP2 may not be disposed in an area where the interior angle of the side surface S-S of the separator SPR increases.

In an embodiment, an edge of the second electrode EL2 may not be in contact with the separator SPR. For example, the edge of the second electrode EL2 may be spaced apart from the second separation pattern UP2. According to an embodiment, the second electrode EL2 and the second separation pattern UP2 may be continuously deposited but may be deposited with a thin thickness enough to block electrical connection therebetween.

Edges of the intermediate layer ML, which is adjacent to each of the conductive patterns CNP1 and CNP2, and edges of the second electrode EL2 may be aligned with each other, and the second electrode EL2 may be insulated from the conductive patterns CNP1 and CNP2. The conductive patterns CNP1 and CNP2 may receive a constant voltage via a separate line.

However, the disclosure should not be limited thereto or thereby, and the edges of the second electrode EL2 adjacent to each of the conductive patterns CNP1 and CNP2 may cover the edges of the intermediate layer ML. The second electrode EL2 may be electrically connected to the conductive patterns CNP1 and CNP2, and the constant voltage may not be applied to the conductive patterns CNP1 and CNP2.

Referring to FIG. 5A again, an encapsulation layer ECL may be disposed on the pixel definition layer 70 and may cover the separator SPR. The encapsulation layer ECL may include a first inorganic layer IL1, an organic layer OL, and a second inorganic layer IL2, which may be sequentially stacked on each other, however, it should not be limited thereto or thereby. According to an embodiment, the encapsulation layer ECL may further include inorganic layers and organic layers.

The first and second inorganic layers IL1 and IL2 may protect the light emitting device layer LDL from moisture and oxygen, and the organic layer OL may protect the light emitting device layer LDL from a foreign substance such as dust particles. The first and second inorganic layers IL1 and IL2 may include a silicon nitride layer, a silicon oxynitride layer, a silicon oxide layer, a titanium oxide layer, or an aluminum oxide layer. The organic layer OL may include an acrylic-based organic layer, however, it should not be particularly limited.

The sensing layer ISL may sense external inputs. The sensing layer ISL may be formed on the light emitting device layer LDL through successive processes. The sensing layer ISL may be disposed directly on the light emitting device layer LDL. In the disclosure, the expression "the sensing layer ISL is disposed directly on the light emitting device layer LDL" means that no intervening elements are present between the sensing layer ISL and the light emitting device layer LDL. For example, a separate adhesive member may not be disposed between the sensing layer ISL and the light emitting device layer LDL, however, this is an example. According to an embodiment, the sensing layer ISL may be provided after being separately formed and may be coupled to or connected to the light emitting device layer LDL by an adhesive member, and it should not be particularly limited.

The sensing layer ISL may include conductive layers MTL1 and MTL2 and insulating layers 71, 72, and 73. The insulating layers 71, 72, and 73 may include first, second, and third sensing insulating layers 71, 72, and 73. However, this is an example, and the number of insulating layers should not be particularly limited.

The first sensing insulating layer 71 may be an inorganic layer including at least one of silicon nitride, silicon oxynitride, and silicon oxide. According to an embodiment, the first sensing insulating layer 71 may be an organic layer including an epoxy resin, an acrylic resin, or an imide-based resin. The first sensing insulating layer 71 may have a single-layer structure or a multi-layer structure of layers stacked on each other in the third direction DR3.

The conductive layers MTL1 and MTL2 may include a first conductive layer MTL1 and a second conductive layer MTL2. The first conductive layer MTL1 may be disposed between the first sensing insulating layer 71 and the second sensing insulating layer 72, and the second conductive layer MTL2 may be disposed between the second sensing insulating layer 72 and the third sensing insulating layer 73. A portion of the second conductive layer MTL2 may be connected to the first conductive layer MTL1 via a contact hole CNT-I formed through the second sensing insulating layer 72. Each of the conductive layers MTL1 and MTL2 may have a single-layer structure or a multi-layer structure of layers stacked on each other in the third direction DR3.

The conductive layer having the single-layer structure may include a metal layer or a transparent conductive layer. The metal layer may include molybdenum, silver, titanium, copper, aluminum, or alloys thereof. The transparent conductive layer may include a transparent conductive oxide, such as indium tin oxide (ITO), indium zinc oxide (IZO), zinc oxide (ZnO), indium zinc tin oxide (IZTO), or the like within the scope of the disclosure. The transparent conductive layer may include conductive polymer such as PEDOT, metal nanowire, graphene, or the like within the scope of the disclosure.

The conductive layer having the multi-layer structure may include metal layers. The metal layers may have a three-layer structure of titanium/aluminum/titanium. The conductive layer having the multi-layer structure may include at least one metal layer and at least one transparent conductive layer.

The first conductive layer MTL1 and the second conductive layer MTL2 may form a sensor to sense the external inputs in the sensing layer ISL. The sensor may be driven in a capacitive method, for example, a mutual capacitive method or a self-capacitive method, however, this is an example. According to an embodiment, the sensor may be driven in a resistive film method, an ultrasonic method, or an infrared method rather than the capacitive method, and it should not be particularly limited.

Each of the first conductive layer MTL1 and the second conductive layer MTL2 may include a transparent conductive oxide or may have a metal mesh shape formed of an opaque conductive material. The first conductive layer MTL1 and the second conductive layer MTL2 may include various materials and various shapes as long as a visibility of the image displayed by the light generated by the light emitting device layer LDL is not deteriorated.

The third sensing insulating layer 73 may include an inorganic layer. The inorganic layer may include at least one of aluminum oxide, titanium oxide, silicon oxide, silicon nitride, silicon oxynitride, zirconium oxide, and hafnium oxide.

According to an embodiment, the third sensing insulating layer 73 may include an organic layer. The organic layer may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyimide-based resin, a polyamide-based resin, and a perylene-based resin.

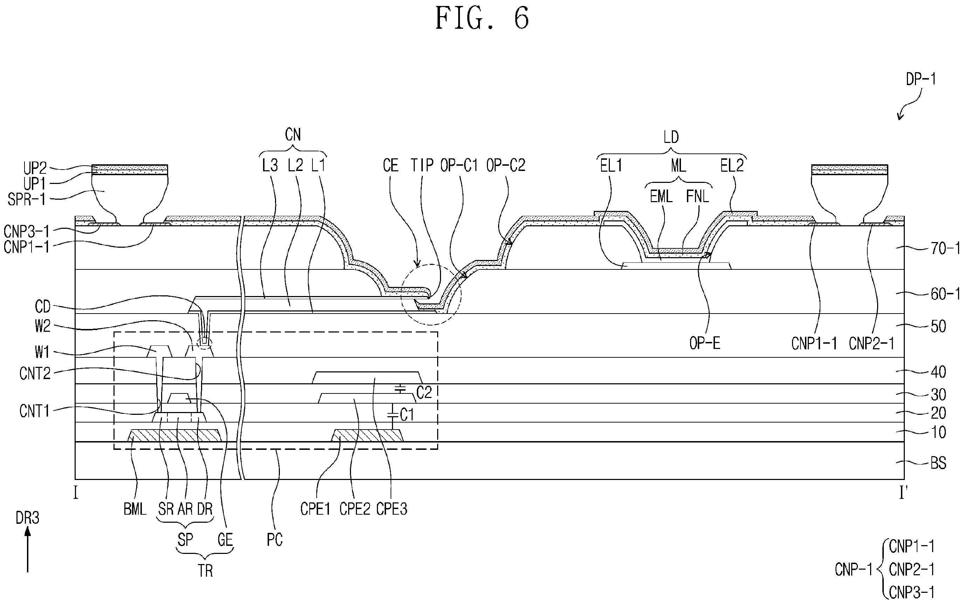

FIG. 6 is an enlarged schematic cross-sectional view of a display panel DP-1 taken along line I-I' of FIG. 4B according to an embodiment. In FIG. 6, the same reference numerals denote the same elements in FIGS. 5A to 5D, and thus, detailed descriptions of the same elements may be omitted.

Referring to FIG. 6, conductive patterns CNP-1 may include a first pattern CNP1-1, a second pattern CNP2-1, and a third pattern CNP3-1. According to an embodiment, the conductive patterns CNP-1 may be disposed on a seventh insulating layer 70-1. A separator SPR-1 may be disposed on the seventh insulating layer 70-1 and may be in contact with the seventh insulating layer 70-1 exposed through and between the conductive patterns CNP-1 adjacent to each other. Accordingly, a separate opening in which the separator SPR-1 is disposed may not be defined through the seventh insulating layer 70-1.

In the embodiment shown in FIG, 6, the seventh insulating layer 70-1 may be referred to as a contact insulating layer that is in contact with the separator SPR-1, and a sixth insulating layer 60-1 may be referred to as a lower insulating layer (a third insulating layer in claims) disposed under or below the contact insulating layer. In an embodiment, a light emitting opening OP-E and a second contact opening OP-C2 may be defined through the seventh insulating layer 70-1, and a first contact opening OP-C1 may be defined through the sixth insulating layer 60-1. For example, in an embodiment, a separation opening to accommodate the separator SPR-1 may not be separately defined through the seventh insulating layer 70-1.

According to an embodiment, a first electrode EL1 and the conductive patterns CNP-1 may be disposed on different layers from each other. Accordingly, the first electrode EL1 may be formed separately in each of the pixels (refer to FIG. 1) or may be formed on an entire surface of the display panel DP-1 in a mesh shape.

FIG. 6 shows an electron transport layer disposed between a light emitting layer EML and a second electrode EL2 as a functional layer FNL, however, the disclosure should not be limited thereto or thereby.

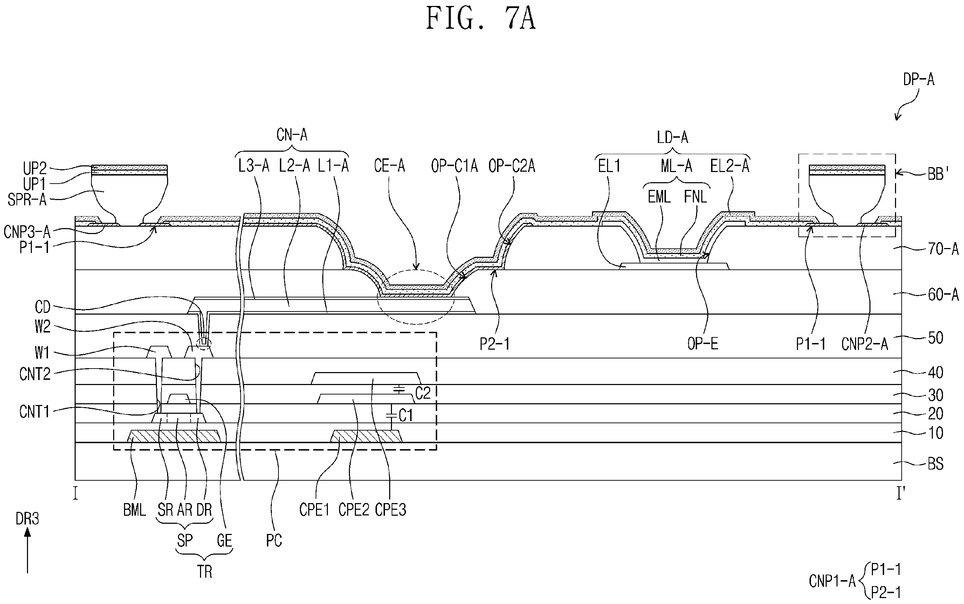

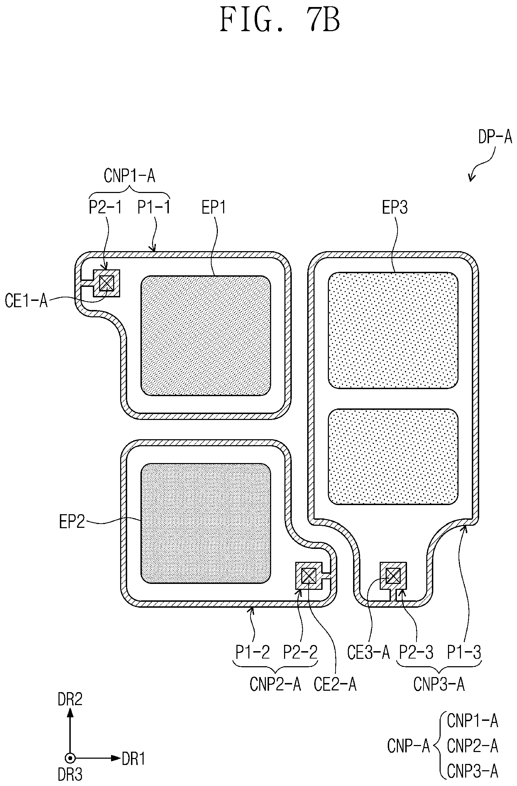

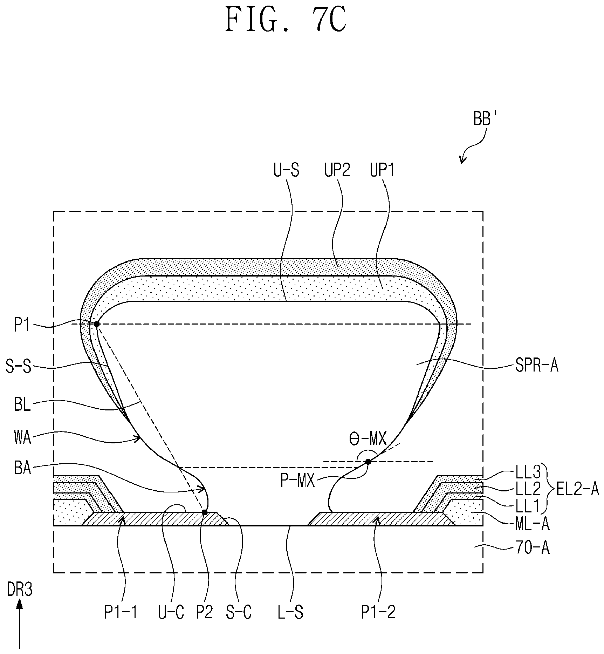

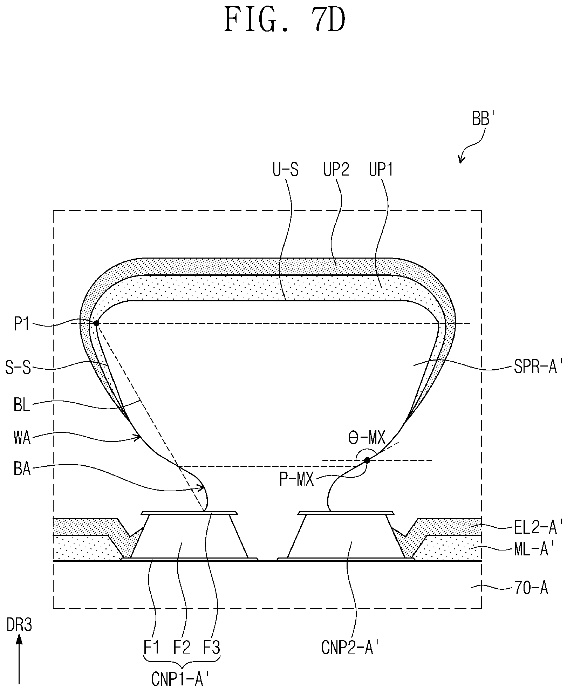

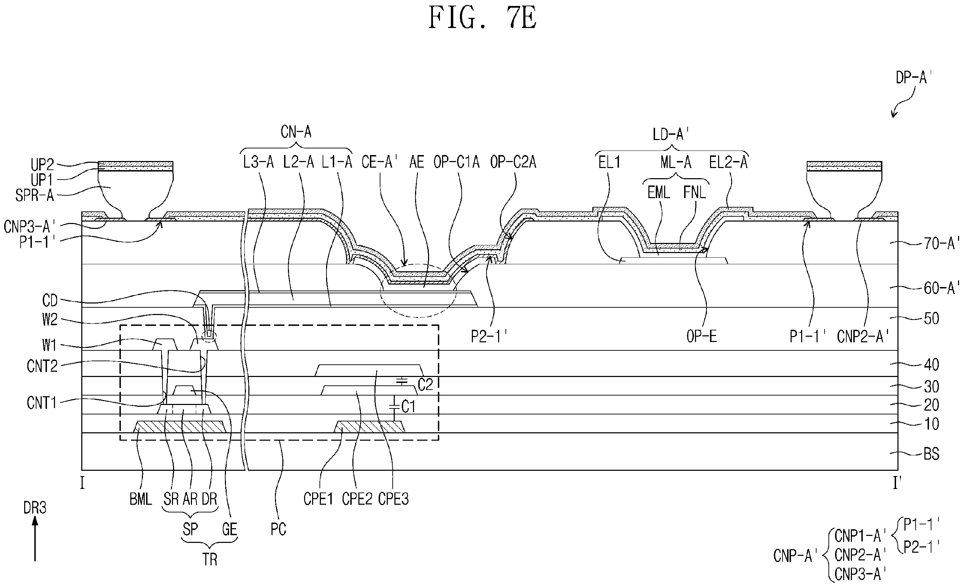

FIG. 7A is an enlarged schematic cross-sectional view of a display panel DP-A taken along line I-I' of FIG. 4B according to an embodiment. FIG. 7B is an enlarged schematic plan view of components of the display panel DP-A according to an embodiment. FIGS. 7C and 7D are enlarged schematic cross-sectional views of an area BB' of FIG. 7A according to embodiments. FIG. 7E is an enlarged schematic cross-sectional view of a display panel DP-A' taken along line I-I' of FIG. 4B according to an embodiment. In FIGS. 7A to 7E, the same reference numerals denote the same elements in FIGS. 5A to 5D, and thus, detailed descriptions of the same elements may be omitted.

Referring to FIGS. 7A to 7C, a connection wiring CN-A of the display panel DP-A may include first, second, and third layers L1-A, L2-A, and L3-A, and edges of the first, second, and third layers L1-A, L2-A, and L3-A, which are adjacent to an emission connection part CE-A, may be aligned with each other. For example, a separate tip part may not be defined in the third layer L3-A.

A first contact opening OP-C1A may be defined through a sixth insulating layer 60-A. The sixth insulating layer 60-A may cover the edge of each of the first, second, and third layers L1-A, L2-A, and L3-A. For example, the edge of each of the first, second, and third layers L1-A, L2-A, and L3-A, which is adjacent to the emission connection part CE-A, may be covered by the sixth insulating layer 60-A. A portion of an upper surface of the connection wiring CN-A may be exposed through the first contact opening OP-C1A of the sixth insulating layer 60-A.

A light emitting opening OP-E may be defined through a seventh insulating layer 70-A to expose a first electrode EL1 of a light emitting device LD-A, and a second contact opening OP-C2A corresponding to the first contact opening OP-C1A may be defined through the seventh insulating layer 70-A. A portion of the upper surface of the connection wiring CN-A may be exposed through the second contact opening OP-C2A of the seventh insulating layer 70-A. The portion of the upper surface of the connection wiring CN-A may be exposed without being covered by the sixth and seventh insulating layers 60-A and 70-A.

Conductive patterns CNP-A may be disposed on the seventh insulating layer 70-A. The conductive patterns CNP-A may include a first pattern CNP1-A, a second pattern CNP2-A, and a third pattern CNP3-A.

As shown in FIG. 7B, the first, second, and third patterns CNP1-A, CNP2-A, and CNP3-A may respectively include first portions P1-1, P1-2, and P1-3 each having a closed-line shape (or a line pattern) when viewed in the plan view and may respectively include second portions P2-1, P2-2, and P2-3 respectively extending from the first portions P1-1, P1-2, and P1-3. In an embodiment, a separator SPR-A (SPR-A' FIG. 7D) may overlap the first portions P1-1, P1-2, and P1-3 each having the closed-line shape (or the line pattern) of the conductive patterns CNP-A.

The first portion P1-1 of the first pattern CNP1-A may surround a first light emitting part EP1 and a first emission connection part CE1-A. The second portion P2-1 of the first pattern CNP1-A may extend in a direction from an inner edge of the first portion P1-1 toward the first light emitting part EP1 and may overlap the first emission connection part CE1-A.

The first portion P1-2 of the second pattern CNP2-A may surround a second light emitting part EP2 and a second emission connection part CE2-A. The second portion P2-2 of the second pattern CNP2-A may extend in a direction from an inner edge of the first portion P1-2 toward the second light emitting part EP2 and may overlap the second emission connection part CE2-A.

The first portion P1-3 of the third pattern CNP3-A may surround a third light emitting part EP3 and a third emission connection part CE3-A. The second portion P2-3 of the third pattern CNP3-A may extend in a direction from an inner edge of the first portion P1-3 toward the third light emitting part EP3 and may overlap the third emission connection part CE3-A.

However, the shape of the second portions P2-1, P2-2, and P2-3 should not be particularly limited as long as the second portions P2-1, P2-2, and P2-3 include areas overlapping the connection wirings CN-A and defining the first, second, and third emission connection parts CE1-A, CE2-A, and CE3-A.

As shown in FIG. 7A, the second portion P2-1 may be disposed in the first and second contact openings OP-C1A and OP-C2A. In an embodiment, the second portion P2-1 may cover an inner side surface of the sixth insulating layer 60-A, which defines the first contact opening OP-C1A, and an inner side surface of the seventh insulating layer 70-A, which defines the second contact opening OP-C2A. The second portion P2-1 may be in contact with the upper surface of the connection wiring CN-A exposed through the first contact opening OP-C1A. According to an embodiment, the emission connection part CE-A may be defined as a portion in which the second portion P2-1 is in contact with an upper surface of the third layer L3-A.

The light emitting device LD-A may include the first electrode EL1, an intermediate layer ML-A, and a second electrode EL2-A. Each of the intermediate layer ML-A and the second electrode EL2-A may be disposed in the first and second contact openings OP-C1A and OP-C2A. The intermediate layer ML-A may cover the second portion P2-1 of the first pattern CNP1-A in the first and second contact openings OP-C1A and OP-C2A. Accordingly, the first pattern CNP1-A and the second electrode EL2-A may be insulated from each other by the intermediate layer ML-A in the first and second contact openings OP-C1A and OP-C2A.

In an embodiment, as the second electrode EL2-A is in contact with the first portion P1-1, the second electrode EL2-A may be electrically connected to the first pattern CNP1-A. Accordingly, the second electrode EL2-A may be electrically connected to the connection wiring CN-A via the second portion P2-1 and may be electrically connected to a connection transistor TR via the connection wiring CN-A. In an embodiment, at least a portion of an area where the second electrode EL2-A is in contact with the first portion P1-1 may overlap the separator SPR-A (SPR-A' FIG. 7D).

As shown in FIG. 7C, the intermediate layer ML-A may be provided to expose at least a portion of an upper surface U-C of each of the first portions P1-1 and P1-2. The second electrode EL2-A may be in contact with the portion of the upper surface U-C of each of the first portions P1-1 and P1-2, which is exposed without being covered by the intermediate layer ML-A. The second electrode EL2-A may be formed through a deposition process different from a deposition process applied to form the intermediate layer MI,-A. This will be described in detail later.

The second electrode EL2-A may include a first layer LL1, a second layer LL2, and a third layer LL3.

The first layer LL1 may be disposed on the intermediate layer ML-A. The first layer LL1 may cover edges of the intermediate layer ML-A and may be in contact with the portion of the upper surface U-C of each of the first portions P1-1 and P1-2, which is exposed without being covered by the intermediate layer ML-A. According to an embodiment, the first layer LL1 may include ytterbium (Yb).

The second layer LL2 may be disposed on the first layer LL1. The second layer LL2 may cover the first layer LL1 and may be in contact with the portion of the upper surface U-C of each of the first portions P1-1 and P1-2, which is exposed without being covered by the intermediate layer ML-A. According to an embodiment, the second layer LL2 may include magnesium (Mg).

The third layer LL3 may be disposed on the second layer LL2. The third layer LL3 may cover the second layer LL2 and may be in contact with the portion of the upper surface U-C of each of the first portions P1-1 and P1-2, which is exposed without being covered by the intermediate layer ML-A. According to an embodiment, the third layer LL3 may include aluminum (Al).

However, a stack structure of the second electrode EL2-A should not be particularly limited, at least one of the first, second, and third layers LL1, LL2, and LL3 may be omitted, and another layer may be added to the first, second, and third layers LL1, LL2, and LL3. A material included in each of the first, second, and third layers LL1, LL2, and LL3 should not be particularly limited.

According to an embodiment, a manufacturing process of the display panel DP-A may not include a process of forming the tip part at the edge of the third layer L3-A of the connection wiring CN-A, and thus, the manufacturing process of the display panel DP-A may be simplified. Compared to the case where the second electrode EL2-A is in contact with the side surface of the connection wiring CN-A, the case where the conductive patterns CNP-A are in contact with the upper surface of the connection wiring CN-A, a contact area between components may increase, so defects in contact between the conductive patterns CNP-A and the connection wiring CN-A may be reduced.

According to an embodiment, since the second electrode EL2-A is in contact with the first portions P1-1, P1-2, and P1-3 of the conductive patterns CNP1-A, CNP2-A, and CNP3-A, each surrounding the corresponding light emitting part among the light emitting parts EP1, EP2, and EP3 and having the closed-line shape, the contact area between the second electrode EL2-A and the conductive patterns CNP1-A, CNP2-A, and CNP3-A may increase. Accordingly, a contact resistance of the second electrode EL2-A may be reduced, and an electrical reliability of the display panel DP-A may be improved. The contact area on the upper surface of the connection wiring CN-A and the conductive patterns CNP1-A, CNP2-A, and CNP3-A may be reduced, and thus, a size of the first contact opening OP-C1A of the sixth insulating layer 60-A and a size of the second contact opening OP-C2A of the seventh insulating layer 70-A may be reduced. Therefore, an area in which the pixels are arranged may be secured, and a high resolution of the display panel DP-A may be readily implemented.

Referring to FIG. 7D, each of conductive patterns CNP1 -A' and CNP2-A' may have a multi-layer structure. Each of the conductive patterns CNP1-A' and CNP2-A' may include a first layer F1, a second layer F2, and a third layer F3.

Each of the first and third layers F1 and F3 may have a thickness smaller than a thickness of the second layer F2. The first and third layers F1 and F3 may include the same material or a similar material, and the second layer F2 may include a material different from the material of each of the first and third layers F1 and F3. The second layer F2 may have an etch rate greater than an etch rate of each of the first and third layers F1 and F3. For example, the second layer F2 may include a material having an etch selectivity with respect to the first and third layers F1 and F3. As an example, each of the first and third layers F1 and F3 may include titanium (Ti), and the second layer F2 may include aluminum (Al). However, the material of the first, second, and third layers F1, F2, and F3 should not be particularly limited.

A side surface of the third layer F3 may protrude outward from a side surface of the second layer F2. For example, the side surface of the second layer F2 may be disposed inside the side surface of the third layer F3 and may have an undercut shape or an overhang structure.

FIG. 7D shows a structure in which an intermediate layer ML-A' is in contact with a portion of the first layer F1, however, the intermediate layer ML-A' may be in contact with a portion of the side surface of the second layer F2.

A second electrode EL2-A' may be in contact with at least a portion of the side surface of the second layer F2. In the case where the intermediate layer ML-A' is in contact with the portion of the side surface of the second layer F2, the second electrode EL2-A' may be in contact with the other portion of the side surface of the second layer F2, which is not in contact with the intermediate layer MI,-A'.

In an embodiment, as the second electrode EL2-A' is in contact with the side surface of the second layer F2 with high conductivity among corresponding patterns CNP1-A' and CNP2-A', the second electrode EL2-A' may be electrically connected to the corresponding patterns CNP1-A' and CNP2-A'.

FIG. 7D shows the portions of the first and second patterns CNP1-A' and CNP2-A' corresponding to the first portions P1-1 and P1-2 (refer to FIG. 7B), however, portions of the first and second patterns CNP1-A' and CNP2-A' corresponding to the second portions P2-1 and P2-2 (refer to FIG. 7B) and portions of the third pattern CNP3-A' (refer to FIG. 7E) corresponding to the first and second portions P1-3 and P2-3 (refer to FIG. 7B) may have the same stack structure as that shown in FIG. 7D.

Referring to FIG. 7E, the display panel DP-A' may further include an additional electrode AE. In FIG. 7E, the same reference numerals denote the same elements in FIGS. 7A to 7D, and thus, detailed descriptions of the same elements may be omitted.

Conductive patterns CNP-A' may include first, second, and third patterns CNP1-A', CNP2-A', and CNP3-A', and each of the first, second, and third patterns CNP1-A', CNP2-A', and CNP3-A' may include first and second portions P1-1' and P2-1'.

The additional electrode AE may be disposed between a connection wiring CN-A and the conductive pattern CNP-A' adjacent to the connection wiring CN-A in a first contact opening OP-C1A. The additional electrode AE may be directly in contact with an upper surface of the connection wiring CN-A exposed through the first contact opening OP-C1A. For example, an emission connection part CE-A' may be defined as an area where the additional electrode AE is in contact with an upper surface of a third layer L3-A. Accordingly, each of the conductive patterns CNP1-A', CNP2-A', and CNP3-A' may be electrically connected to the connection wiring CN-A via the additional electrode AE.

The additional electrode AE may have substantially the same structure as that of a first electrode EL1 of a light emitting device LD-A' and may include substantially the same material or a similar material as the first electrode EL1 of the light emitting device LD-A'. For example, the additional electrode AE may be formed through the same process as the first electrode EL1.

As the additional electrode AE covers the connection wiring CN-A exposed through the first contact opening OP-C1A, the connection wiring CN-A may not be exposed in processes of forming a seventh insulating layer 70-A' and the conductive patterns CNP1-A', CNP2-A', and CNP3-A'. Accordingly, the connection wiring CN-A may be prevented from being damaged.

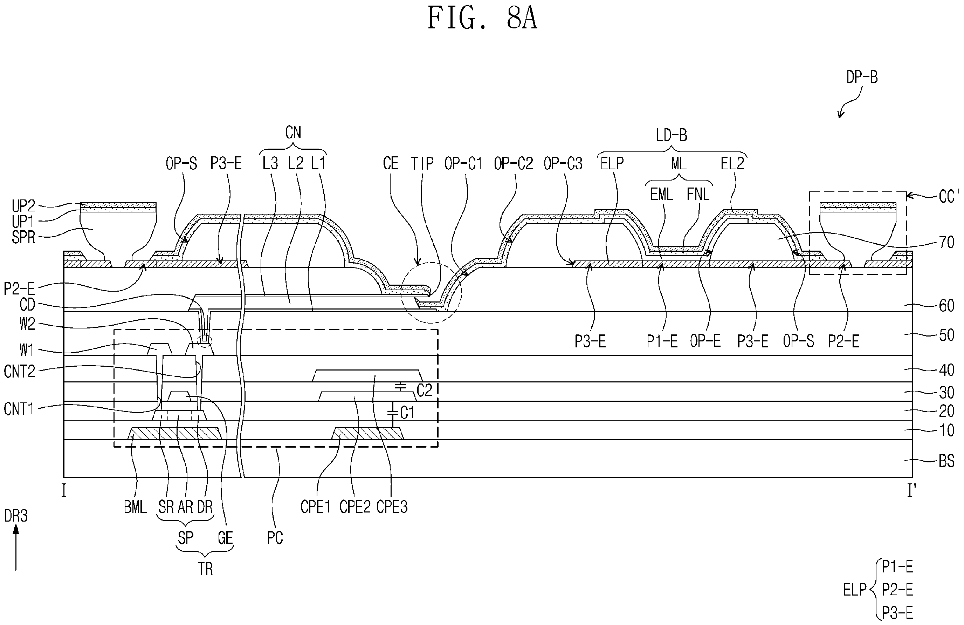

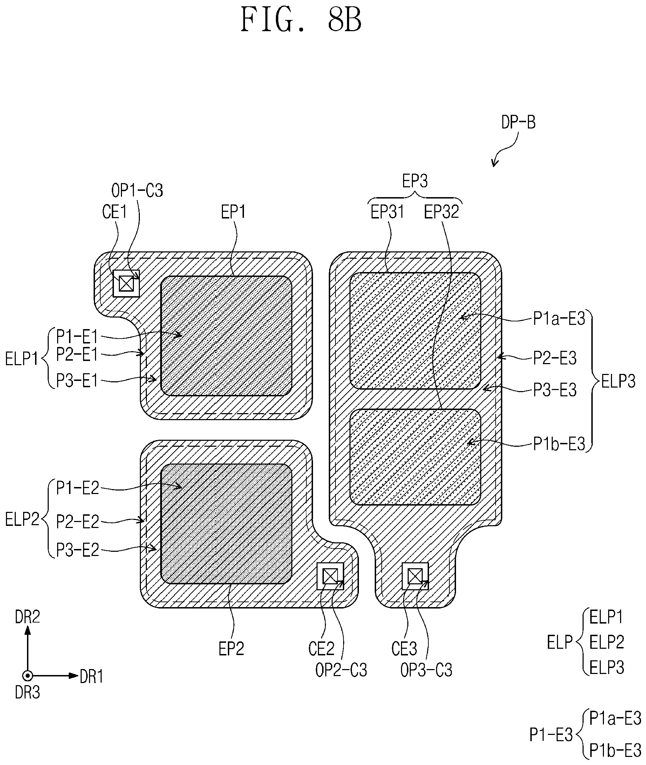

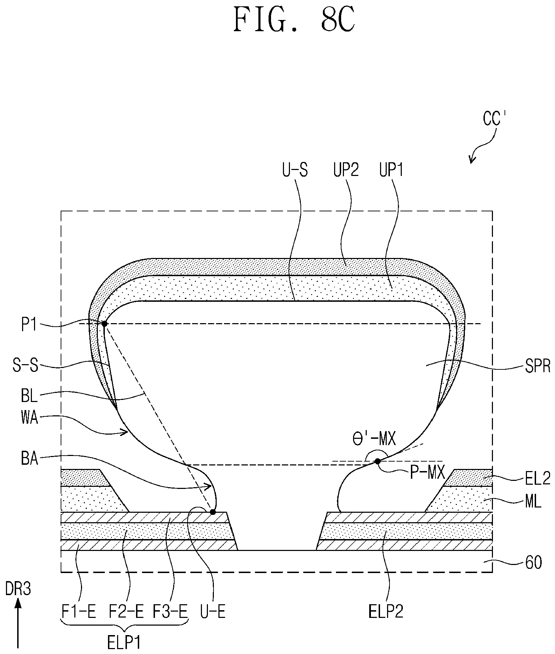

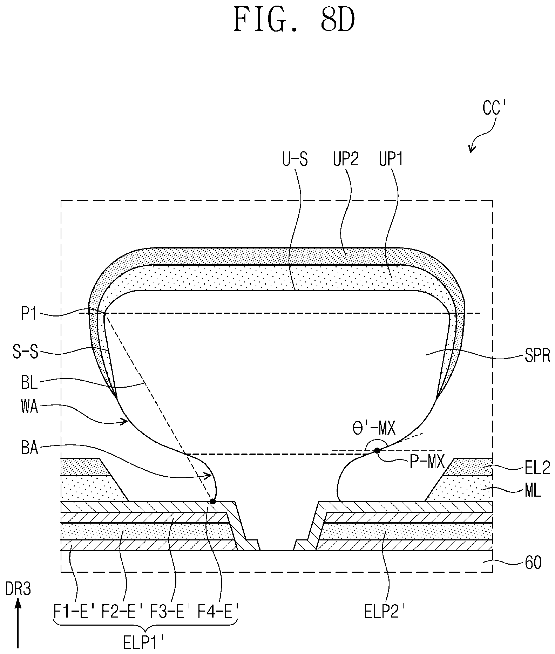

FIG. 8A is an enlarged schematic cross-sectional view of a display panel DP-B taken along line I-I' of FIG. 4B according to an embodiment. FIG. 8B is an enlarged schematic plan view of components of the display panel DP-B according to an embodiment. FIGS. 8C and 8D are enlarged schematic cross-sectional views of an area CC' of FIG. 8A according to embodiments.

Referring to FIG. 8A, a light emitting device LD-B of the display panel DP-B may include an electrode pattern ELP, an intermediate layer ML disposed on the electrode pattern ELP, and a second electrode EL2 disposed on the intermediate layer ML.

The electrode pattern ELP may include a first portion P1-E, a second portion P2-E, and a third portion P3-E. The first portion P 1-E may be exposed through a light emitting opening OP-E defined through a seventh insulating layer 70. For example, the first portion P1-E may overlap a light emitting part when viewed in the plan view. The second portion P2-E may overlap a separator SPR. The third portion P3-E may connect the first portion P1-E and the second portion P2-E.

A third contact opening OP-C3 may be defined through the electrode pattern ELP. The third contact opening OP-C3 may correspond to a first contact opening OP-C1, and the third contact opening OP-C3 may have a size equal to or greater than a size of the first contact opening OP-C1 when viewed in the plan view.

When compared with the embodiments described with reference to FIGS. 5A to 7D, an embodiment shows a structure in which a conductive pattern is integral with a first electrode of the light emitting device LD-B. For example, the electrode pattern ELP of an embodiment has the structure in which the conductive pattern and the first electrode are integrally provided. The conductive pattern and the first electrode integral with each other may be formed through the same process, may have the same structure, and may include the same material or a similar material. According to an embodiment, a patterning process to form the conductive pattern using a separate mask may not be performed, and thus, a manufacturing process of the display panel DP-B may be simplified.

Referring to FIG. 8B, the electrode pattern ELP may include a first electrode pattern ELP1, a second electrode pattern ELP2, and a third electrode pattern ELP3. The first electrode pattern ELP1 may be an electrode pattern included in a first light emitting device in which a first light emitting part EP1 is defined, and the second electrode pattern ELP2 may be an electrode pattern included in a second light emitting device in which a second light emitting part EP2 is defined, and the third electrode pattern ELP3 may be an electrode pattern included in a third light emitting device in which a third light emitting part EP3 is defined. Each of the first to third electrode patterns ELP1, ELP2, and ELP3 may include a first portion P1-E1, P1-E2, and P1-E3, a second portion P2-E1, P2-E2, and P2-E3, and a third portion P3-E1, P3-E2, and P3-E3.

A first portion P1-E1 of the first electrode pattern ELP1 may overlap the first light emitting part EP1, and a third contact opening OP1-C3 of the first electrode pattern ELP1 may overlap a first emission connection part CE1. A first portion P1-E2 of the second electrode pattern ELP2 may overlap the second light emitting part EP2, and a third contact opening OP2-C3 of the second electrode pattern ELP2 may overlap a second emission connection part CE2. A first portion P1-E3 of the third electrode pattern ELP3 may overlap the third light emitting part EP3, and a third contact opening OP3-C3 of the third electrode pattern ELP3 may overlap a third emission connection part CE3.

The third light emitting part EP3 may include two sub-light emitting parts EP31 and EP32 spaced apart from each other in the second direction DR2, and the first portion P1-E3 of the third electrode pattern ELP3 may include two sub-portions P1a-E3 and P1b-E3 respectively overlapping the two sub-light emitting parts EP31 and EP32, however, the disclosure should not be limited thereto or thereby. According to an embodiment, the third light emitting part may be integral with the first portion of the third electrode pattern.

Referring to FIG. 8C, each of electrode patterns ELP1 and ELP2 may have a three-layer structure. Each of the electrode patterns ELP1 and ELP2 may include a first layer F1-E, a second layer F2-E, and a third layer F3-E, which may be sequentially stacked on each other in the third direction DR3.

Each of the first and third layers F1-E and F3-E may have a relatively thin thickness compared with the second layer F2-E. The first and third layers F1-E and F3-E may have the same material or a similar material as each other. The first and third layers F1-E and F3-E may include a transparent conductive material. The second layer F2-E may include a material different from that of the first and third layers F1-E and F3-E. As an example, each of the electrode patterns ELP1 and ELP2 may have a stack structure of ITO/Ag/ITO, however, materials for the first, second, and third layers F1-E, F2-E, and F3-E should not be particularly limited.

According to an embodiment, as the electrode patterns ELP1 and ELP2 include a reflective metal, a light irradiated to a separator SPR during an exposure process of the separator SPR may be reflected by the electrode patterns ELP1 and ELP2. Accordingly, a degree of curing of the separator SPR may increase compared with a case where the electrode patterns ELP1 and ELP2 do not include the reflective metal.

Even though the degree of curing of the separator SPR is high, the separator SPR may be removed more in a portion thereof adjacent to the electrode patterns ELP1 and ELP2 since an adhesion between the separator SPR and the electrode patterns ELP1 and ELP2 is weakened during a patterning process of the separator SPR.

Accordingly, in a patterned separator SPR, an interior angle formed between a side surface of the separator SPR and an upper surface U-E of the electrode patterns ELP1 and ELP2 at an area adjacent to the upper surface U-S among the wide area WA may decrease, and the interior angle at a boundary between the wide area WA and a bottleneck area BA may increase. Thus, a maximum interior angle θ'-MX may increase, a probability of the second electrode EL2 being deposited may be lowered, and the second electrode EL2 may be clearly divided for each pixel.

Referring to FIG. 8D, each of electrode patterns ELP1" and ELP2" may have a four-layer structure. Each of the electrode patterns ELP1" and ELP2" may include first, second, third, and fourth layers F1-E", F2-E", F3-E", and F4-E". Each of the electrode patterns ELP1" and ELP2" according to an embodiment may further include the fourth layer F4-E" compared with the electrode patterns ELP1 and ELP2 described with reference to FIGS. 8A to 8C. In FIG. 8D, the same reference numerals denote the same elements in FIGS. 8A to 8C, and thus, detailed descriptions of the same elements may be omitted.

The fourth layer F4-E' may be disposed on the third layer F3-E'. The fourth layer F4-E' may cover an upper surface of the third layer F3-E' and a side surface of each of the first, second, and third layers F1-E', F2-E', and F3-E'. The fourth layer F4-E' may include a transparent conductive material. As an example, the fourth layer F4-E' may include indium tin oxide (ITO). The fourth layer F4-E' may have a single-layer structure.

After a patterning process is performed on the seventh insulating layer 70 (refer to FIG. 8A), an outer side surface of a first electrode pattern ELP1' may be exposed via the separation opening OP-S (refer to FIG. 8A) defined through the seventh insulating layer 70 (refer to FIG. 8A). According to an embodiment, as the fourth layer F4-E' covers an outer side surface of the second layer F2-E', the second layer F2-E' may be prevented from being damaged in the subsequent process. Accordingly, the electrode patterns ELP1' and ELP2' may be prevented from being damaged, and thus, an anode electrode of the first light emitting device LD-B (refer to FIG. 8A) may be prevented from malfunctioning.

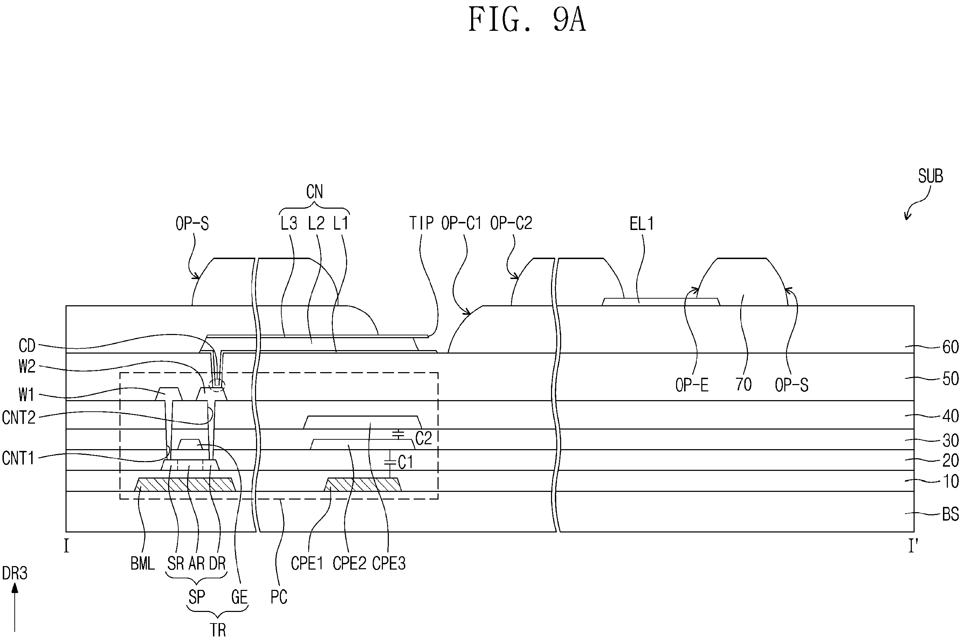

FIGS. 9A to 9D are schematic cross-sectional views of a method of manufacturing the display panel according to an embodiment. FIGS. 9A to 9D show the manufacturing method of the display panel DP described with reference to FIG. 5A. In FIGS. 9A to 9D, the same reference numerals denote the same elements in FIGS. SAto 5D, and thus, detailed descriptions of the same elements may be omitted.

Referring to FIGS. 9A to 9D, the manufacturing method of the display panel DP may include providing a base substrate SUB, forming the conductive patterns CNP, forming the separator SPR, and forming the second electrode EL2.

Referring to FIG. 9A, the manufacturing method of the display panel DP (refer to FIG. 5A) may include the providing of the base substrate SUB.

In an embodiment, the base substrate SUB may include the base layer BS, the connection transistor TR disposed on the base layer BS, the connection wiring CN electrically connected to the connection transistor TR, the sixth insulating layer 60 covering the portion of the connection wiring CN, the first electrode EL1 disposed on the sixth insulating layer 60, and the seventh insulating layer 70 disposed on the sixth insulating layer 60 to allow the first electrode EL1 to be exposed.

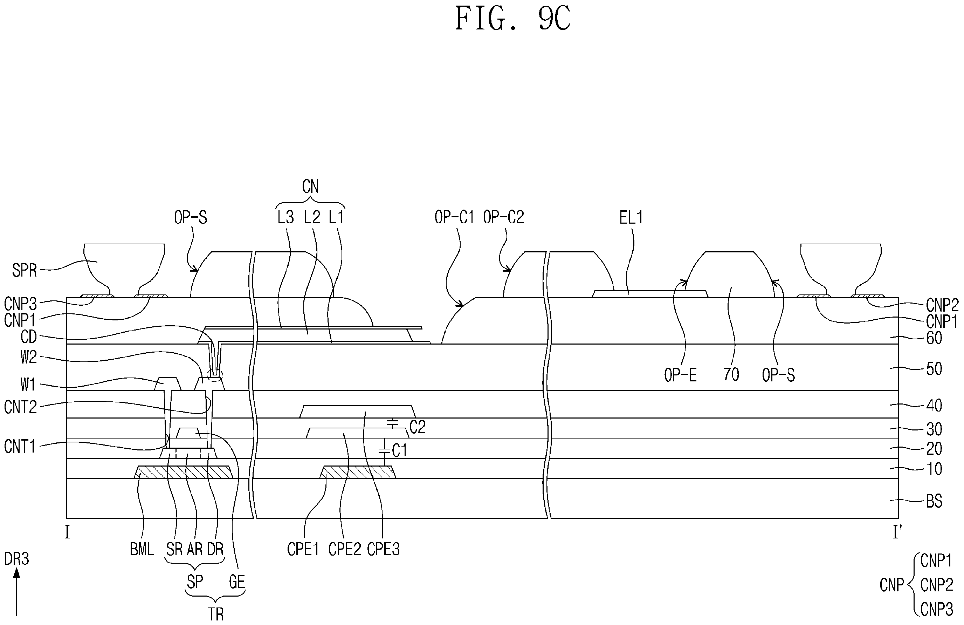

In the disclosure, the base substrate SUB may provide a base surface on which the separator SPR (refer to FIG. 9C) is disposed, and the base surface may correspond to an upper surface of an organic insulating layer. In an embodiment, the contact insulating layer may correspond to the sixth insulating layer 60, and the base surface may be the upper surface of the sixth insulating layer 60.

In an embodiment, the connection wiring CN may include the first, second, and third layers L1, L2, and L3, and the tip part TIP may be defined in the third layer L3. The first contact opening OP-C1 may be defined through the sixth insulating layer 60 to expose the side surface of the third layer L3 in which the tip part TIP of the connection wiring CN is defined and the side surface of each of the first and second layers L1 and L2 adjacent to the side surface of the third layer L3.

The light emitting opening OP-E through which the portion of the first electrode EL1 is exposed, the second contact opening OP-C2 corresponding to the first contact opening OP-C1, and the separation opening OP-S providing the space in which the separator SPR (refer to FIG. 9C) is disposed may be defined through the seventh insulating layer 70.

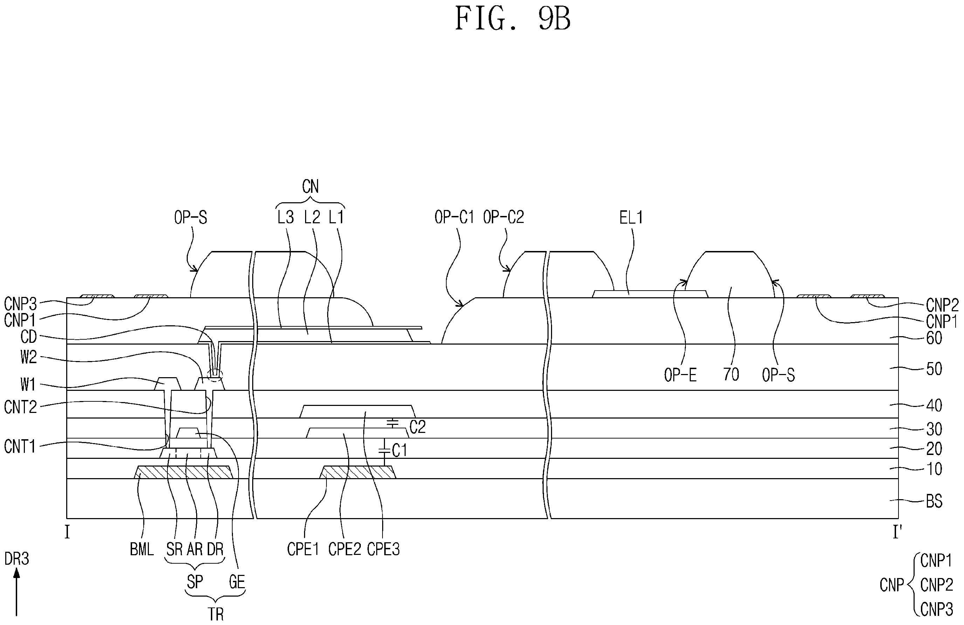

Referring to FIG. 9B, the manufacturing method of the display panel may include the forming of the conductive patterns CNP. In an embodiment, the conductive patterns CNP may be formed on the portions of the sixth insulating layer 60, which are exposed through the separation opening OP-S of the seventh insulating layer 70.

The conductive patterns CNP may include the first, second, and third patterns CNP1, CNP2, and CNP3 spaced apart from each other. The first, second, and third patterns CNP1, CNP2, and CNP3 may have the closed-line shape when viewed in the plan view as described above.

Referring to FIG. 9C, the manufacturing method of the display panel DP may include the forming of the separator SPR. The separator SPR may be formed on the sixth insulating layer 60. The separator SPR may be disposed in the separation opening OP-S. The separator SPR may be disposed between the conductive patterns CNP adjacent to each other and may be patterned along the conductive patterns CNP when viewed in the plan view.

The separator SPR may be formed through a photolithography process. The preliminary separator may be formed by coating the material for the separator SPR on the sixth insulating layer 60, and the patterned separator SPR may be formed by performing an exposure process and an etching process. The preliminary separator may include a negative resist, and thus, the separator SPR may have the shape whose width decreases going from the upper surface U-S (refer to FIG. 5C) to the lower surface L-S (refer to FIG. 5C).

According to an embodiment, a portion of the coated preliminary separator, which is adjacent to the conductive patterns CNP, may be readily removed by the conductive patterns CNP having the hydrophilic surface. Accordingly, the separator SPR may include the wide area WA (refer to FIG. 5C) and the bottleneck area BA (refer to FIG. 5C) when viewed in the cross-section. According to an embodiment, the maximum interior angle θ-MX (refer to FIG. 5C) of the side surface S-S (refer to FIG. 5C) of the separator SPR in the cross-section may be larger than that of the comparative example in which the conductive pattern is not formed.

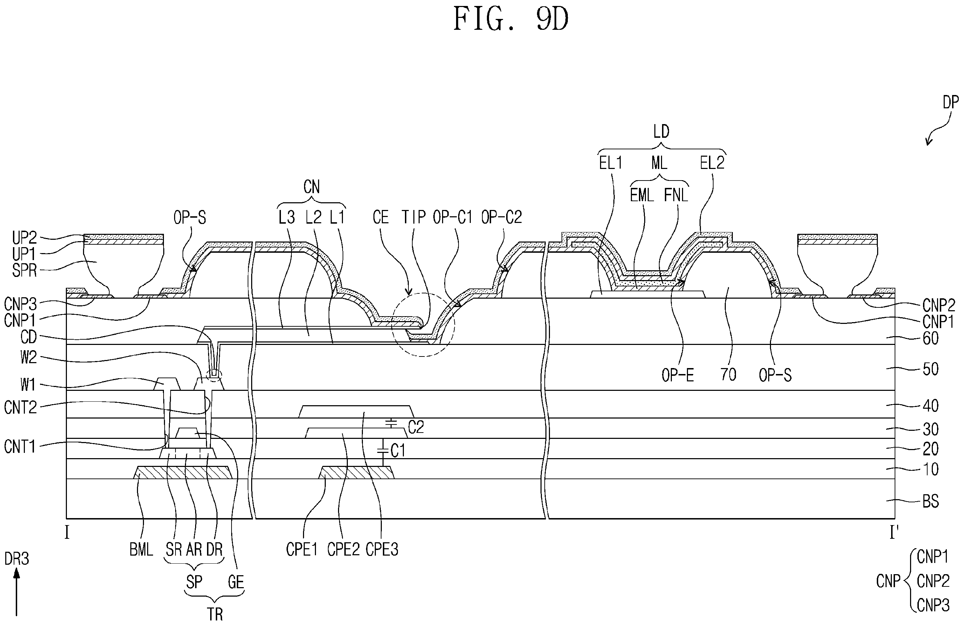

Referring to FIG. 9D, the manufacturing method of the display panel may include the forming of the second electrode EL2. In the forming of the second electrode EL2, the intermediate layer ML including the light emitting layer EML and the functional layer FNL and the second electrode EL2 may be sequentially stacked each other on the first electrode EL1 to form the light emitting devices LD.

The intermediate layer ML and the second electrode EL2 may be commonly formed in the pixels using the open mask, however, the intermediate layer ML and the second electrode EL2 may not be formed on at least a portion of the side surface of the separator SPR.

The first separation pattern UP1 having the same structure as that of the intermediate layer ML may be formed on the upper surface U-S (refer to FIG. 5C) of the separator SPR during the forming of the intermediate layer MI,, and the second separation pattern UP2 having the same structure as that of the second electrode EL2 may be formed during the forming of the second electrode EL2. The first separation pattern UP1 may be spaced apart from the intermediate layer MI,, and the second separation pattern UP2 may be spaced apart from or electrically disconnected from the second electrode EL2. Thus, each of the intermediate layer ML and the second electrode EL2 may be separated for each pixel.

The second electrode EL2 may be in contact with the side surface of the second layer L2 of the connection wiring CN to electrically connect the second electrode EL2 to the connection transistor TR.

The display panel DP-1 described with reference to FIG. 6 may be manufactured through a method similar to the manufacturing method of the display panel DP described with reference to FIGS. 9A to 9D. However, different from the base substrate SUB of FIG. 9A including the seventh insulating layer 70 through which the separation opening OP-S is defined, the display panel DP-1 of FIG. 6 is provided with the seventh insulating layer 70-1 through which a separation opening is not defined, and different from the conductive patterns CNP and the separator SPR of FIGS. 9B and 9C which are disposed on the sixth insulating layer 60, the display panel DP-1 of FIG. 6 may include the conductive patterns CNP-1 and the separator SPR-1 disposed on the seventh insulating layer 70-1.

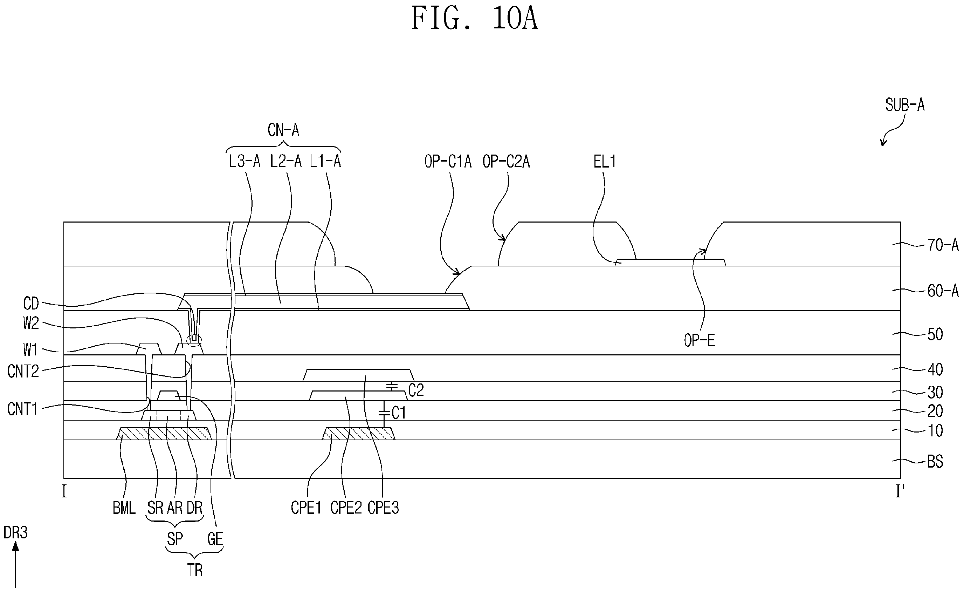

FIGS. 10A to 10F are schematic cross-sectional views of a method of manufacturing the display panel according to an embodiment. FIGS. 10A to 10F show the manufacturing method of the display panel DP-A described with reference to FIG. 7A. In FIGS. 10A to 10F, the same reference numerals denote the same elements in FIGS. 7A to 7D, and thus, detailed descriptions of the same elements may be omitted.

Referring to FIGS. 10A to 10F, the manufacturing method of the display panel DP-A may include providing a base substrate SUB-A, forming the conductive patterns CNP-A, forming the separator SPR-A, and forming the second electrode EL2-A.

Referring to FIG. 10A, the manufacturing method of the display panel may include the providing of the base substrate SUB-A. In an embodiment, the base substrate SUB-A may include a base layer BS, the connection transistor TR, the connection wiring CN-A, the sixth insulating layer 60-A (60-A' of FIG. 7E), the first electrode EL1, and the seventh insulating layer 70-A. In an embodiment, the contact insulating layer may correspond to the seventh insulating layer 70-A, and a base surface may be an upper surface of the seventh insulating layer 70-A.

In an embodiment, the connection wiring CN-A may include the first, second, and third layers L1-A, L2-A, and L3-A, and the edges of the first, second, and third layers L1-A, L2-A, and L3-A may be aligned with each other. The first contact opening OP-C1A may be defined through the sixth insulating layer 60-A to expose the portion of the upper surface of the connection wiring CN-A. The sixth insulating layer 60-A may cover the side surface of each of the first, second, and third layers L1-A, L2-A, and L3-A.

The light emitting opening OP-E through which the portion of the first electrode EL1 is exposed and the second contact opening OP-C2A corresponding to the first contact opening OP-C1A may be defined through the seventh insulating layer 70-A.

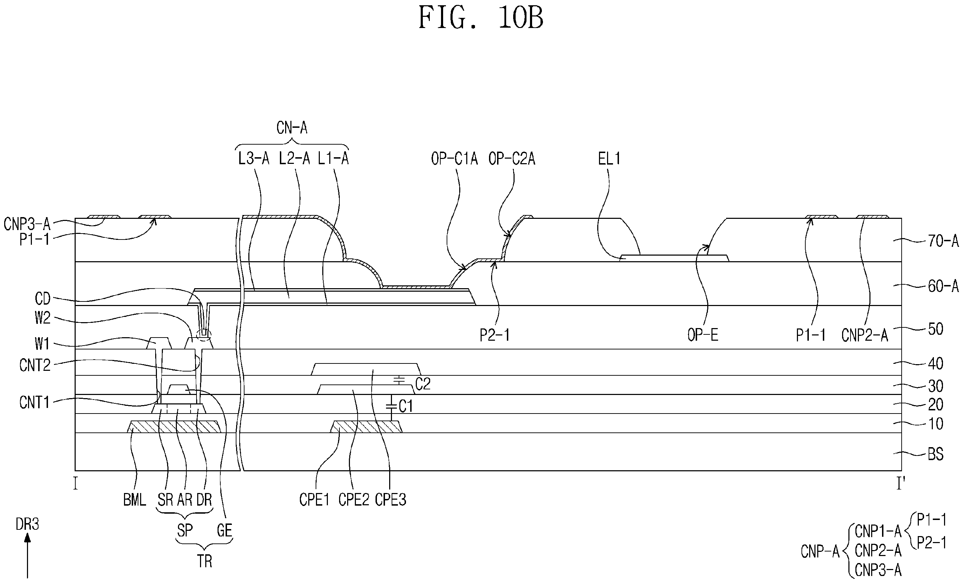

Referring to FIG. 10B, the manufacturing method of the display panel may include the forming of the conductive patterns CNP-A.

In an embodiment, the conductive patterns CNP-A may include the first, second, and third patterns CNP1-A, CNP2-A, and CNP3-A, and the first pattern CNP1-A may include the first portion P1-1 and the second portion P2-1 extending inward from the first portion P1-1. Descriptions on the first and second portions P1-1 and P2-1 of the first pattern CNP1-A may be applied to the second and third patterns CNP2-A and CNP3-A.

As the second portion P2-1 of the first pattern CNP1-A is in contact with the upper surface of the connection wiring CN-A exposed through the first contact opening OP-C1A, the first pattern CNP1-A may be electrically connected to the connection wiring CN-A.

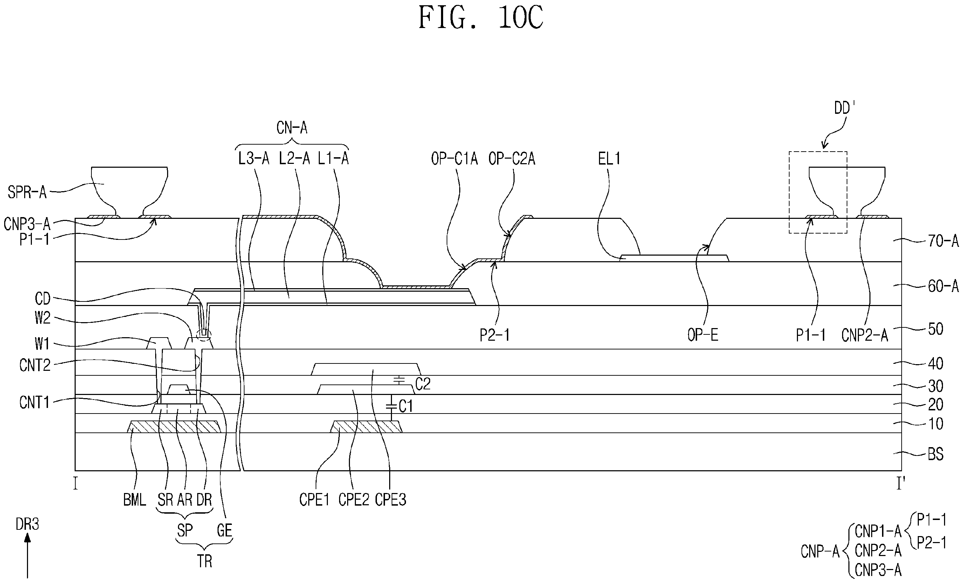

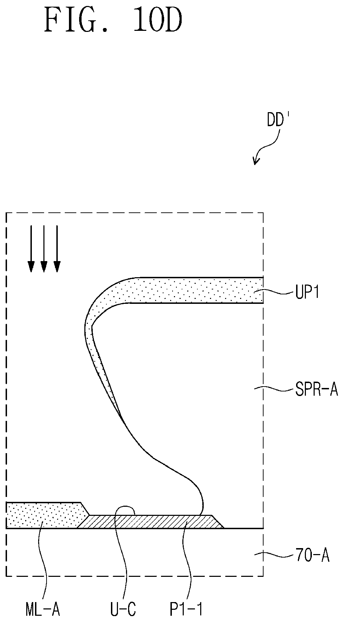

Referring to FIG. 10C, the manufacturing method of the display panel may include the forming of the separator SPR-A. The details of the forming of the separator SPR described with reference to FIG. 9C may be applied to the forming of the separator SPR-A. FIGS. 10D through 10E illustrate a portion of the display device DD' of FIG. 10C according to an embodiment.

Referring to FIGS. 10D to 10F, the manufacturing method of the display panel may include the forming of the second electrode EL2-A. In the forming of the second electrode EL2-A, the intermediate layer ML-A including the light emitting layer EML and the functional layer FNL and the second electrode EL2-A may be sequentially stacked on each other on the first electrode EL1 to form the light emitting device LD-A. Hereinafter, the method of forming the intermediate layer ML-A and the second electrode EL2-A will be described in detail.

Referring to FIG. 10D, the intermediate layer ML-A may be formed. According to an embodiment, the intermediate layer ML-A may be formed through a thermal evaporation manner. At least the portion of the upper surface U-C of the first portion P1-1 may be exposed without being covered by the intermediate layer MI,-A.

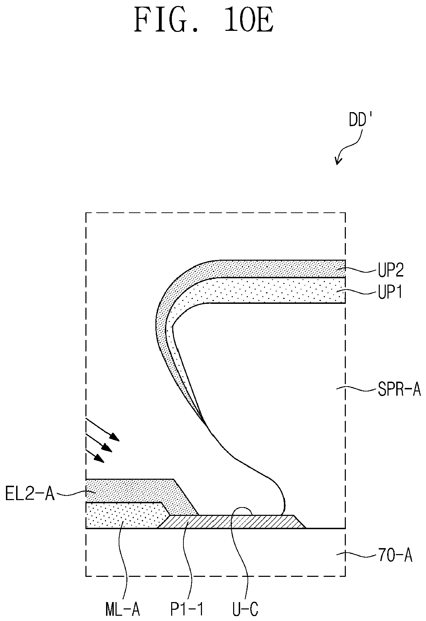

Referring to FIG. 10E, the second electrode EL2-A may be formed. The second electrode EL2-A may be formed through a deposition process different from the process applied to form the intermediate layer ML-A. The second electrode EL2-A may be formed through the deposition process capable of depositing a deposition material at a low incident angle. According to an embodiment, the second electrode EL2-A may be formed by a sputtering method.

The second electrode EL2-A may cover the portion of the upper surface U-C of the first portion P1-1 exposed without being covered by the intermediate layer ML-A. Accordingly, the second electrode EL2-A may be electrically connected to the connection wiring CN-A and the connection transistor TR via the first pattern CNP1-A.

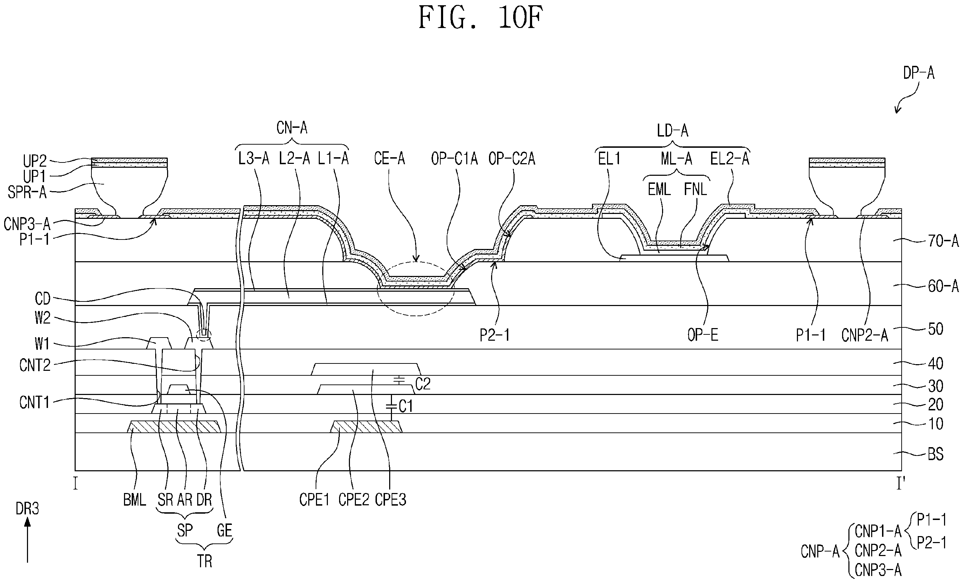

As shown in FIG. 10F, as the intermediate layer ML-A and the second electrode EL2-A may not be disposed on at least the portion of the side surface of the separator SPR-A, the intermediate layer ML-A and the second electrode EL2-A may be separated for each pixel by the separator SPR-A. In an embodiment, the intermediate layer ML-A and the second electrode EL2-A may be continuously formed in the first and second contact openings OP-C1A and OP-C2A.

The display panel DP-A' described with reference to FIG. 7E may be formed through a manufacturing method similar to the manufacturing method of the display panel DP-A described with reference FIGS. 10A to 10F. However, in case that the display panel DP-A' of FIG. 7E is manufactured, the display panel DP-A' may further include the additional electrode AE (refer to FIG. 7E) compared with the base substrate SUB-A provided in FIG. 10A, and the additional electrode AE (refer to FIG. 7E) may be patterned through the same process as the first electrode EL1.

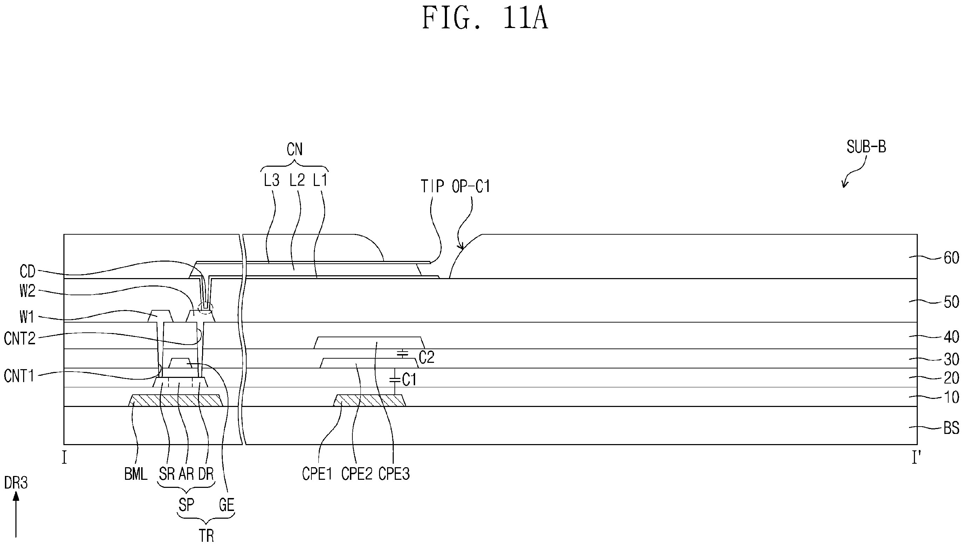

FIGS. 11A to 11E are schematic cross-sectional views of a method of manufacturing the display panel according to an embodiment. FIGS. 11A to 11E show the manufacturing method of the display panel DP-B described with reference to FIG. 8A. In FIGS. 11A to 11E, the same reference numerals denote the same elements in FIGS. 5A to 5D and 8A to 8D, and thus, detailed descriptions of the same elements may be omitted.

Referring to FIGS. 11A to 11E, the manufacturing method of the display panel DP-B may include providing a base substrate SUB-B, forming the electrode patterns ELP1, ELP2, and ELP3, forming the sixth insulating layer 60, forming the separator SPR, and forming the second electrode EL2.

Referring to FIG. 11A, the manufacturing method of the display panel may include the providing of the base substrate SUB-B. In an embodiment, the base substrate SUB-B may include a base layer BS, the connection transistor TR, the connection wiring CN, and the sixth insulating layer 60. In an embodiment, the contact insulating layer may correspond to the sixth insulating layer 60, and a base surface may be an upper surface of the sixth insulating layer 60.

In an embodiment, the connection wiring CN may include the first, second, and third layers L1, L2, and L3, and the tip part TIP may be defined in the third layer L3. The first contact opening OP-C1 may be defined through the sixth insulating layer 60 to expose the side surface of the third layer L3 in which the tip part TIP is defined and the side surface of the first and second layers L1 and L2 adjacent to the side surface of the third layer L3.

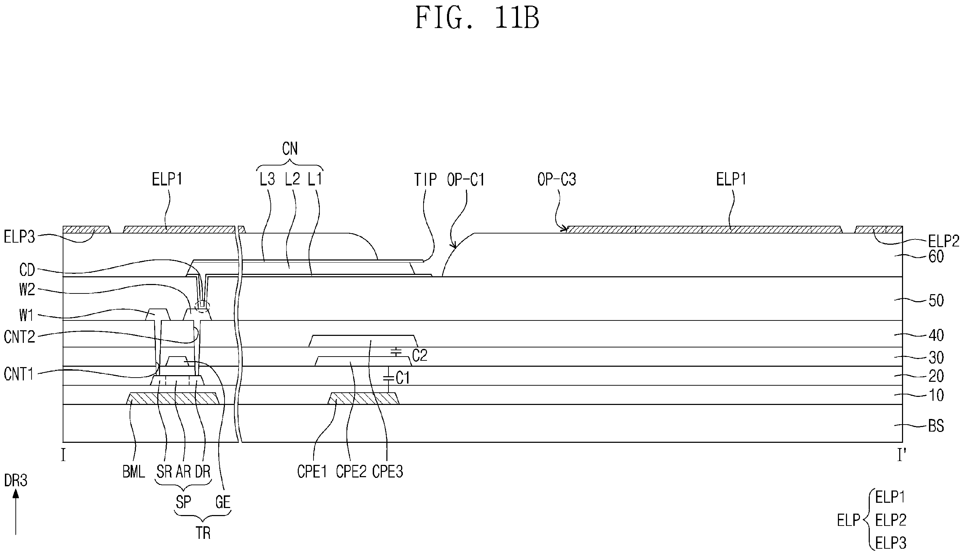

Referring to FIG. 11B, the manufacturing method of the display panel may include the forming of the electrode patterns ELP1, ELP2, and ELP3.

In an embodiment, the electrode patterns ELP1, ELP2, and ELP3 may include the first, second, and third electrode patterns ELP1, ELP2, and ELP3 spaced apart from each other. The third contact opening OP-C3 corresponding to the first contact opening OP-C1 may be defined through each of the electrode patterns ELP1, ELP2, and ELP3.

Each of the electrode patterns ELP1, ELP2, and ELP3 may have the three-layer structure as described with reference to FIG. 8C or may have the four-layer structure as described with reference to FIG. 8D.

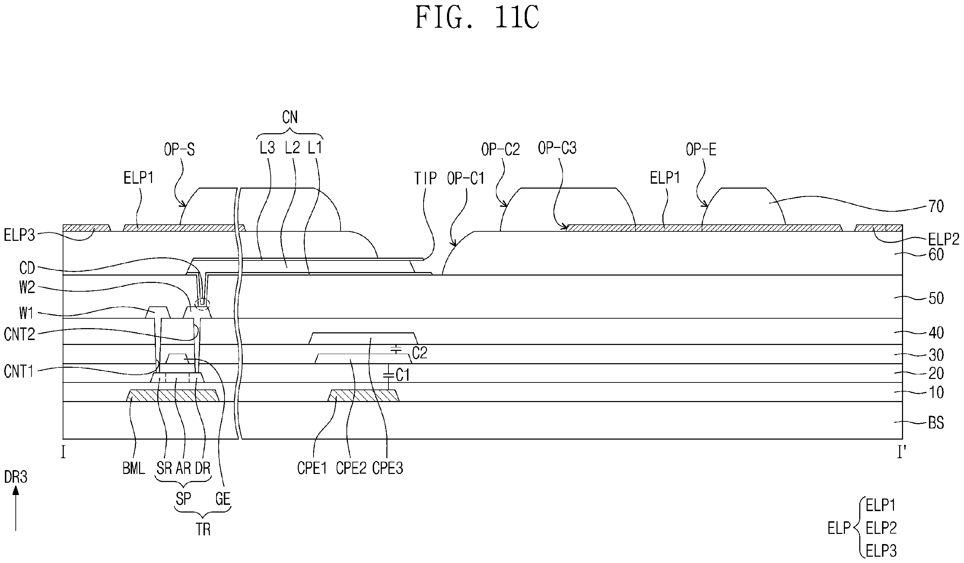

Referring to FIG. 11C, the manufacturing method of the display panel may include the forming of the upper insulating layer. In an embodiment, the upper insulating layer may correspond to the seventh insulating layer 70. The light emitting opening OP-E through which the portion of the first electrode pattern ELP1 is exposed, the second contact opening OP-C2 corresponding to the first contact opening OP-C1, and the separation opening OP-S through which an outer edge portion of the first electrode pattern ELP1 is exposed may be defined through the seventh insulating layer 70.

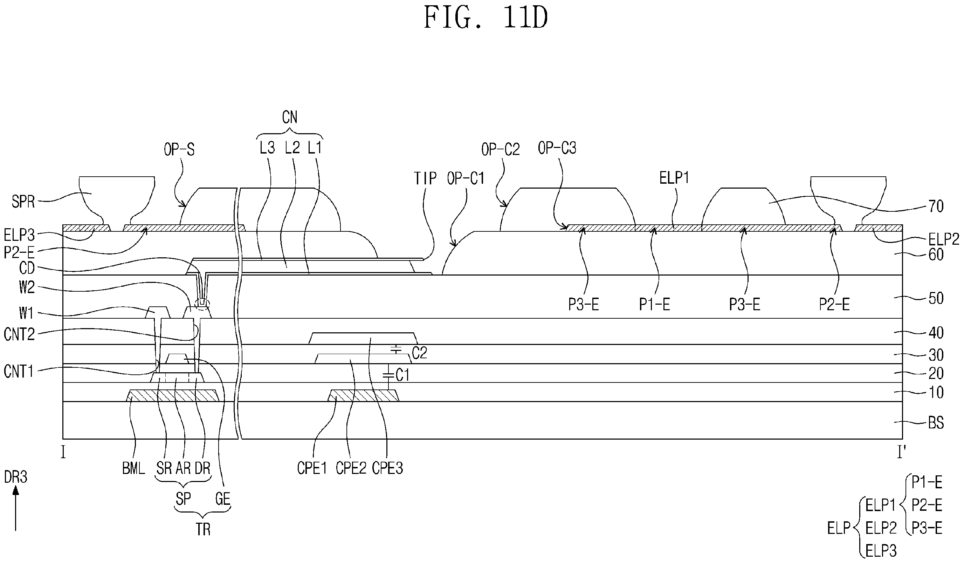

Referring to FIG. 11D, the manufacturing method of the display panel DP-B may include the forming of the separator SPR. Details of the forming of the separator SPR described with reference to FIG. 9C may be applied to the forming of the separator SPR in FIG. 11D.

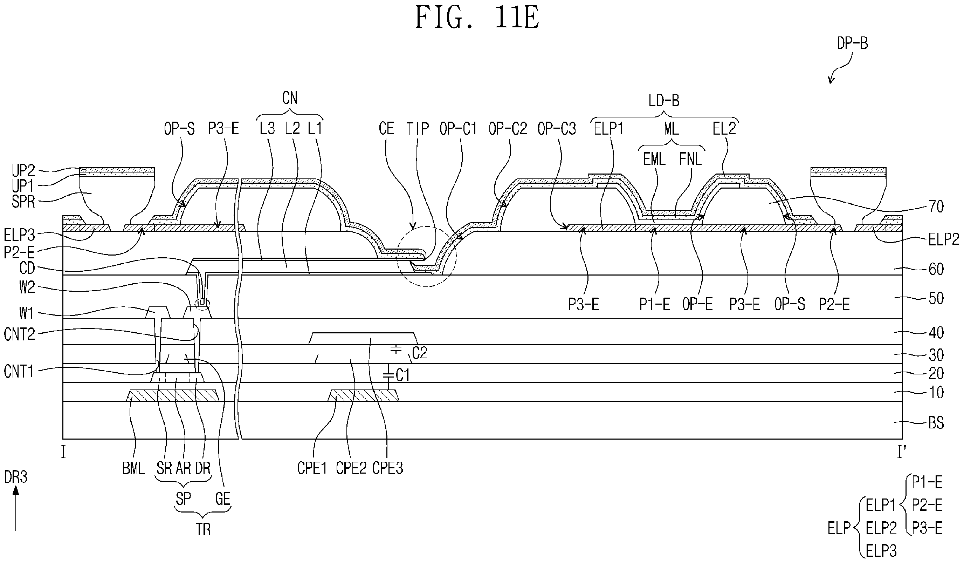

Referring to FIG. 11E, the manufacturing method of the display panel may include the forming of the second electrode EL2. Details of the forming of the second electrode EL2 described with reference to FIG. 9D may be applied to the forming of the second electrode EL2 in FIG. 11E. In an embodiment, each of the electrode patterns ELP1, ELP2, and ELP3 may include the first portion P1-E exposed through the light emitting opening OP-E of the seventh insulating layer 70, the second portion P2-E overlapping the separator SPR, and the third portion P3-E connecting the first and second portions P1-E and P2-E.

Although the embodiments have been described, it is understood that the disclosure should not be limited to these embodiments but various changes and modifications can be made by one of ordinary skill in the art within the scope of the disclosure and as hereinafter claimed. Therefore, the disclosed subject matter should not be limited to any single embodiment described herein, and the scope of the disclosure shall be determined according to the attached claims.

## Claims

1. A display panel comprising:
a first pixel comprising:
a light emitting device comprising:
a first electrode; and a second electrode; and
a transistor electrically connected to the second electrode;
a second pixel comprising:
a light emitting device comprising:
a first electrode; and a second electrode; and
a transistor electrically connected to the second electrode;
a first insulating layer disposed on the transistor of each of the first pixel and the second pixel;
a conductive pattern disposed on the first insulating layer and comprising a first pattern corresponding to the first pixel and a second pattern corresponding to the second pixel and spaced apart from the first pattern; and
a separator disposed between the first pattern and the second pattern and contacting a portion of the first insulating layer, which is exposed and not covered by the first pattern and the second pattern, to separate the second electrode of the first pixel from the second electrode of the second pixel.

2. The display panel of claim 1, further comprising:
a separation pattern disposed on the separator,
wherein the separation pattern and the second electrode of each of the first pixel and the second pixel have a same structure.

3. The display panel of claim 1 or 2, wherein the separator comprises a bottleneck area adjacent to the first insulating layer and a wide area disposed at an upper side of the bottleneck area in a cross-section perpendicular to a direction in which the separator extends.

4. The display panel of any preceding claim, wherein the first pattern has a substantially closed-line shape in a plan view.

5. The display panel of any preceding claim, wherein the conductive pattern is insulated from the second electrode of the first pixel, and the conductive pattern receives a constant voltage.

6. The display panel of any preceding claim, further comprising:
a connection wiring partially covered by the first insulating layer and electrically connecting the transistor of the first pixel to the second electrode of the first pixel.

7. The display panel of any preceding claim, wherein the first pattern is spaced apart from the first electrode of the first pixel; and/or
wherein the conductive pattern has a single-layer structure and comprises a transparent conductive material; and/or
wherein each of the first insulating layer and the separator comprises an organic material, and the conductive pattern comprises a hydrophilic surface; and/or
wherein the second electrode of the first pixel contacts the first pattern and at least a portion of an area where the second electrode of the first pixel contacts the first pattern overlap the separator.

8. The display panel of claim 6, wherein
the first insulating layer includes a contact opening that exposes a portion of the connection wiring, the connection wiring comprises:
a first layer;
a second layer disposed on the first layer; and
a third layer disposed on the second layer, the third layer and the first layer comprising a same material,
an edge of each of the first layer and the third layer, which is exposed and not covered by the first insulating layer, protrudes more than an edge of the second layer, which is exposed and not covered by the first insulating layer, and
the second electrode of the first pixel contacts a side surface of the second layer exposed and not covered by the first insulating layer.

9. The display panel of claim 6, further comprising:
a second insulating layer disposed below the first insulating layer, covering a portion of the connection wiring, and including a first contact opening that exposes a portion of an upper surface of the connection wiring, wherein
the first insulating layer includes a light emitting opening that exposes a portion of the first electrode of the first pixel and a second contact opening corresponding to the first contact opening, and
the first pattern comprises:
a first portion having a substantially closed-line shape in a plan view; and
a second portion extending from the first portion and overlapping the first contact opening in a plan view.

10. The display panel of claim 9, wherein the second portion contacts the portion of the upper surface of the connection wiring, which is exposed through the first contact opening of the second insulating layer.

11. The display panel of claim 9, further comprising:
an additional electrode disposed between the portion of the upper surface of the connection wiring, which is exposed through the first contact opening of the second insulating layer, and the second portion, and
the additional electrode and the first electrode of the first pixel comprise a same material.

12. The display panel of claim 9, wherein a portion of an upper surface of the first portion contacts the second electrode of the first pixel.

13. The display panel of claim 9, wherein the first pattern comprises:
a first layer;
a second layer disposed on the first layer; and
a third layer disposed on the second layer, an edge of each of the first layer and the third layer protrudes more than an edge of the second layer, and the second electrode of the first pixel contacts a side surface of the second layer in the first portion.

14. The display panel of any preceding claim, further comprising:
a third insulating layer disposed on the first insulating layer and including a light emitting opening that exposes the first electrode of the first pixel and a separation opening,
wherein the separator is disposed in the separation opening.

15. The display panel of any preceding claim, wherein the first pattern is integral with the first electrode of the first pixel; optionally,
wherein the first pattern comprises:
a first layer comprising a transparent conductive material;
a second layer disposed on the first layer and comprising a material different from the first layer; and
a third layer, disposed on the second layer, and the third layer and the first layer comprise a same material; optionally,
wherein the first pattern comprises a fourth layer comprising a transparent conductive material, and
the fourth layer covers a side surface of each of the first layer, the second layer, and the third layer and an upper surface of the third layer.
